# EUROPÄISCHE PATENTANMELDUNG

(11) **EP 2 381 222 A1**
(43) Veröffentlichungstag der Anmeldung: **26.10.2011**
(21) Anmeldenummer: 10405087.7
(22) Anmeldetag: 22.04.2010
(51) Int. Cl.: G01D 5/347

(54) **Führungssystem mit relativ zueinander bewegbaren Körpern und Vorrichtung zur Bestimmung einer Position mittels optischem Abtasten einer Massskala.**

(71) Anmelder: Schneeberger Holding AG, 4914 Roggwil (CH)
(72) Erfinder: Mischler, Ernst, 4914 Roggwil (CH); Lehmann, Roger, 4566 Kriegstetten (CH); Innerhofer, Edith, CH-8057 Zürich (CH); Urban, Claus, CH-8248 Uhwiesen (CH)
(74) Vertreter: EGLI-EUROPEAN PATENT ATTORNEYS

(57) **Zusammenfassung**

Die Vorrichtung (5) zur Bestimmung einer Position umfasst eine Massskala (10) mit mindestes einer Markierung (11, 12) zur Kennzeichnung einer Position und einen relativ zur Massskala (10) bewegbaren Messkopf (21) zum optischen Abtasten der Massskala (10). Der Messkopf (21) umfasst ein telezentrisches optisches System (30) zur Erzeugung eines Bildes der Massskala (10) und einen Sensor (40) zum Erfassen des Bildes der Massskala (10) und zum Bereitstellen von Signalen, welche Signale eine Bestimmung der Position des Messkopfes (21) relativ zur Massskala (10) ermöglichen. Das telezentrische optische System (30) umfasst ein in einem Abstand zur Massskala (10) angeordnetes und eine optische Achse (34) aufweisendes erstes Linsenelement (33) und eine Apertur (35), welche an einem Fokus (F1) des ersten Linsenelements (33) auf einer von der Massskala (10) abgewandten Seite des Linsenelements (33) angeordnet ist. Das telezentrische optische System (30) umfasst einen Block (31), wobei das erste Linsenelement (33) integraler Bestandteil des Blocks (31) ist und ein erster Bereich (32.1) einer Oberfläche (32) des Blocks (31) eine Oberfläche des ersten Linsenelements (33) bildet und die Apertur in Form einer ersten Spiegelfläche (35) realisiert ist, welche an einem zweiten Bereich (32.2) der Oberfläche (32) des Blocks (31) ausgebildet ist und bezüglich der optischen Achse (34) des ersten Linsenelements (33) geneigt (ϕ<90°) ist.

## Beschreibung

Die Erfindung bezieht sich auf eine Vorrichtung zur Bestimmung einer Position mittels einer Massskala und einem relativ zur Massskala bewegbaren Messkopf zum optischen Abtasten der Massskala und ein Führungssystem mit einem ersten Körper und einem relativ zum ersten Körper bewegbaren, an dem ersten Körper geführten zweiten Körper und mit einer Vorrichtung zur Bestimmung einer Position.

Es sind beispielsweise Vorrichtungen zur Bestimmung einer Position bekannt, welche eine Massskala und einen relativ zur Massskala bewegbaren Messkopf zum optischen Abtasten der jeweiligen Massskala umfassen, wobei die Massskala eine oder mehrere Markierungen zur Kennzeichnung einer Position aufweist und der Messkopf ein optisches System zur Erzeugung eines Bildes der Massskala und einen Sensor zum Erfassen des Bildes der Massskala und zum Bereitstellen von Signalen umfasst, welche Signale eine Bestimmung der Position des Messkopfes relativ zur Massskala ermöglichen.

Abhängig davon, wie die jeweilige Massskala ausgebildet ist, können derartige Vorrichtungen beispielsweise verwendet werden, um eine relative Veränderung einer Position des Messkopfes relativ zu einer Ausgangsposition zu messen oder eine absolute Position des Messkopfes zu registrieren.

Um zu erreichen, dass derartige Vorrichtungen relative Veränderungen der Position des Messkopfes bezüglich der Massskala messen können, kann die jeweilige Massskala beispielsweise als inkrementale Skala ausgebildet sein und dementsprechend eine Folge von mehreren identischen, periodisch angeordneten Markierungen, welche in gleichen Abständen längs einer vorgegebenen Linie ("Spur") angeordnet sind, umfassen. Um eine optische Abtastung einer derartigen inkrementalen Massskala zu ermöglichen, kann das optische System in einer einfachen Variante beispielsweise aus einer Linse bestehen, welche ein optisches Bild der jeweiligen Markierungen auf einen ortsfest bezüglich der Linse angeordneten Sensor in Form eines fotoelektrischen Detektors projiziert. Um relative Veränderungen der Position des Messkopfes bezüglich der Massskala zu messen, kann der Messkopf entlang der Spur der Markierungen bewegt werden. Die Bewegung des Messkopfes resultiert dabei in einer periodischen Veränderung eines Signals, welche beispielsweise Aufschluss gibt über die Anzahl der Markierungen, an welchen der Sensor vorbeibewegt wurde. Weiterhin können Signale, welche für verschiedene Positionen des Messkopfes entlang der Spur der Markierungen registriert wurden, interpoliert werden, sodass es möglich ist, die Position des Messkopfes relativ zu Markierungen mit einer Ungenauigkeit zu bestimmen, welche kleiner als der Abstand benachbarter Markierungen ist.

Die vorstehend genannten Vorrichtungen zur Bestimmung einer Position können auch ausgelegt sein, eine absolute Position des Messkopfes bezüglich der Massskala festzustellen. Zu diesem Zweck kann die Massskala längs einer vorgegebenen Linie ("Spur") eine oder mehrere Referenz-Markierungen, welche jeweils eine bestimmte absolute Position spezifizieren, aufweisen. Zur Bestimmung der Position kann ein Messkopf der vorstehend genannten Art längs der vorgegebenen Linie bewegt werden, um die jeweiligen Referenz-Markierungen mittels des Messkopfes optisch abzutasten. Die Bewegung des Messkopfes resultiert dabei in einer Veränderung eines Signals, welche anzeigt, ob sich der Messkopf an einer der Referenz-Markierungen befindet oder nicht. Um die jeweilige absolute Position des Messkopfes an einem beliebigen Ort zu bestimmen, kann beispielsweise eine Änderung der relativen Position des Messkopfes bezüglich einer bestimmten Referenz-Markierung gemessen werden, wobei die jeweilige Änderung der relativen Position des Messkopfes durch Abtasten der Markierungen einer inkrementalen Massskala bestimmt werden kann.

Vorrichtungen zur Bestimmung einer Position der vorstehend genannten Art werden beispielsweise verwendet in Kombination mit Führungssystemen (z.B. Linearführungen oder Drehführungen), welche einen ersten Körper und einen relativ zum ersten Körper bewegbaren, an dem ersten Körper geführten zweiten Körper umfassen, und haben dabei die Aufgabe, eine Bestimmung der Position des zweiten Körpers relativ zum ersten Körper zu ermöglichen. Zu diesem Zweck kann beispielsweise die Massskala der jeweiligen Vorrichtung zur Bestimmung einer Position ortsfest relativ zum ersten Körper und der jeweilige Messkopf ortsfest relativ zum zweiten Körper angeordnet sein.

Hinsichtlich Führungssystemen der vorstehend genannten Art besteht zurzeit ein Trend zu einer fortschreitenden Miniaturisierung. Dementsprechend besteht insbesondere ein Bedarf an Vorrichtungen zur Positionsbestimmung der vorstehend genannten Art, welche in Führungen mit "kleinen" Abmessungen integriert werden können. Weiterhin sollen Vorrichtungen zur Positionsbestimmung der vorstehend genannten Art eine Positionsbestimmung mit einer grossen Genauigkeit ermöglichen, wobei diese Genauigkeit selbst dann gewährleistet sein soll, wenn der zweite Körper mit einer relativ grossen Geschwindigkeit relativ zum ersten Körper bewegt wird. Weiterhin sollten Vorrichtungen zur Positionsbestimmung möglichst kostengünstig herzustellen sein und mit möglichst geringem Montageaufwand in ein Führungssystem integrierbar sein.

Hinsichtlich der vorstehend genannten Anforderungen wurden bisher erste Ansätze verfolgt, welche allerdings lediglich einzelne Teilaspekte dieser Anforderungen berücksichtigen.

Aus WO 2005/033621 A1 und WO 2007/003065 A1 sind beispielsweise Linearführungssysteme mit einem ersten Körper in Form einer Führungsschiene und einem längs der Führungsschiene bewegbaren zweiten Körper und mit einer Vorrichtung der vorstehend genannten Art zur Bestimmung einer Position des zweiten Körpers relativ zur Führungsschiene bekannt, bei welchen Führungssystemen die jeweilige Massskala mittels einer Bearbeitung einer Oberfläche der jeweiligen Führungsschiene realisiert ist. Die jeweilige Massskala ist mit einem Messkopf zum optischen Abtasten abtastbar, wobei WO 2005/033621 A1 und WO 2007/003065 A1 allerdings keine Angaben darüber enthalten, wie ein derartiger Messkopf konstruiert sein könnte. Die Massskala ist in diesem Fall demnach kein separates Teil, welches an der Führungsschiene montiert werden muss, sondern in die Oberfläche der Führungsschiene integriert. Diese Integration der Massskala in die Führungsschiene ist folglich Platz sparend, da die einzelnen Markierungen einer Massskala selbst nur wenig Platz beanspruchen. Da die Massskala nicht als separates Teil realisiert ist, welches an der Führungsschiene montiert werden müsste, entfallen weiterhin aufwändige Arbeitsschritte (z.B. eine Justierung eines separaten Teils relativ zur Führungsschiene und eine dauerhafte Fixierung des separaten Teils an der Führungsschiene).

Aus US 7186969 B2 ist eine Vorrichtung zur Positionsbestimmung mit einer Massskala und mit einem relativ zur Massskala bewegbaren Messkopf zum optischen Abtasten der Massskala bekannt, wobei der Messkopf ein sogenanntes "telezentrisches" optisches System zur Erzeugung eines Bildes der Massskala und einen Sensor zum Erfassen des Bildes der Massskala und zum Bereitstellen von Signalen umfasst, welche Signale eine Bestimmung der Position des Messkopfes relativ zur Massskala ermöglichen. In diesem Fall umfasst das telezentrische optische System ein in einem Abstand zur Massskala angeordnetes und eine optische Achse aufweisendes erstes Linsenelement und eine Apertur in Form einer lichtdurchlässigen Öffnung, welche in einer aus einem für Licht nicht durchlässigen Material gefertigten Blende ausgebildet ist, wobei diese Apertur an einem Fokus des ersten Linsenelements auf einer von der Massskala abgewandten Seite des Linsenelements angeordnet ist. Im Falle dieses telezentrischen optischen Systems hat die Apertur aufgrund der genannten Anordnung der Apertur den Effekt, dass die Apertur einen Lauf von Lichtstrahlen durch das optische System (Strahlengang) derart einschränkt, dass zu dem Bild der Massskala, welches mittels des optischen Systems erzeugbar ist, ausschliesslich Lichtstrahlen beitragen können, welche (von der Massskala ausgehend) parallel zur optischen Achse des Linsenelements auf das Linsenelement treffen bzw. allenfalls innerhalb eines "kleinen" Winkelbereichs, dessen Grösse von der Grösse der jeweiligen Apertur abhängt (und welcher umso kleiner ist, je kleiner die Fläche der Apertur ist), zur optischen Achse geneigt sind. Diese Apertur hat den Effekt, dass die Grösse des jeweiligen Bildes der Massskala, welches das optische System auf dem Sensor erzeugt, sich nicht bzw. relativ wenig ändert, wenn der Abstand zwischen der Massskala und dem Linsenelement variiert werden sollte. Das vorstehend genannte optische System hat demnach den Vorteil, dass das jeweilige Bild der Massskala mit einer relativ grossen Tiefenschärfe erzeugt wird und dementsprechend ein vorgegebener Abstand des Messkopfes bezüglich der Massskala nur mit einer relativ grossen Toleranz eingehalten werden muss. Folglich kann der Messkopf mit relativ einfachen Mitteln mit der jeweils erforderlichen Genauigkeit relativ zur Massskala platziert werden, sodass die Montage des Messkopfes relativ zur Massskala verhältnismässig einfach durchführbar ist. Die genannte Toleranz ist insbesondere umso grösser, je kleiner die Fläche der jeweiligen Apertur ist. Andererseits hat das vorstehend genannte optische System den Nachteil, dass es relativ viel Platz beansprucht, insbesondere in einer Richtung senkrecht zur Massskala. Einer Miniaturisierung des Messkopfes sind dadurch Grenzen gesetzt, mit dem Ergebnis, dass ein derartiger Messkopf wegen seines relativ grossen Platzbedarfs für kleine Führungssysteme nicht geeignet ist.

Ausserdem werden zur Realisierung des optischen Systems relativ viele verschiedene Einzelteile benötigt, welche aus unterschiedlichen Materialien mit unterschiedlichen Eigenschaften hergestellt sind und mit grosser Präzision in vorgegebenen Abständen montiert werden müssen. Das Linsenelement ist beispielsweise ein separater Körper, welcher aus einem lichtdurchlässigen Material gefertigt ist. Die Blende, in welcher die Apertur ausgebildet ist, ist ein weiterer separater Körper, welcher (wie erwähnt) aus einem für Licht nicht durchlässigen Material gefertigt ist, zur Herstellung der Apertur bearbeitet werden muss und am Fokus des Linsenelements platziert sein muss. Die Herstellung des Messkopfes ist deshalb aufwändig und dementsprechend teuer.

Der vorliegenden Erfindung liegt die Aufgabe zugrunde, die genannten Nachteile zu vermeiden und eine Vorrichtung zur Bestimmung einer Position zu schaffen, welche einen ein telezentrisches optisches System umfassenden Messkopf zum optischen Abtasten einer Massskala aufweist, wobei der Messkopf relativ wenig Platz beanspruchen und einfach aufgebaut sein soll. Die Vorrichtung soll auch in Kombination mit einem Führungssystem, welches einen ersten Körper und einen relativ zum ersten Körper bewegbaren zweiten Körper umfasst, verwendbar sein.

Diese Aufgabe wird gelöst durch eine Vorrichtung zur Bestimmung einer Position mit den Merkmalen des Patentanspruchs 1.

Diese Vorrichtung umfasst eine Massskala mit mindestes einer

Markierung zur Kennzeichnung einer Position und einen relativ zur Massskala bewegbaren Messkopf zum optischen Abtasten der Massskala, welcher Messkopf ein telezentrisches optisches System zur Erzeugung eines Bildes der Massskala und einen Sensor zum Erfassen des Bildes der Massskala und zum Bereitstellen von Signalen umfasst, welche Signale eine Bestimmung einer Position des Messkopfes relativ zur Massskala ermöglichen. Das telezentrische optische System umfasst ein in einem Abstand zur Massskala angeordnetes und eine optische Achse aufweisendes erstes Linsenelement und eine Apertur, welche an einem Fokus des ersten Linsenelements auf einer von der Massskala abgewandten Seite des Linsenelements angeordnet ist.

Als "Apertur" wird in diesem Zusammenhang eine "Einrichtung" verstanden, welche eine Ausbreitung von Lichtstrahlen innerhalb eines optischen Systems auf diejenigen Lichtstrahlen beschränkt, welche auf die jeweilige Einrichtung treffen. Eine derartige Einrichtung kann beispielsweise, wie oben erwähnt, als lichtdurchlässige Öffnung in einer Blende aus einem für Licht nicht durchlässigen Material realisiert sein, wobei die jeweilige Apertur durch den Rand der Öffnung begrenzt ist. Alternativ kann eine "Apertur" auch als reflektierender Spiegel realisiert sein, wobei diese Apertur durch den Rand des jeweiligen Spiegels begrenzt ist.

Im Folgenden wird eine an einem Fokus eines Linsenelements angeordnete Apertur auch "telezentrische Apertur" genannt.

Im Falle der erfindungsgemässen Vorrichtung umfasst das telezentrische optische System einen eine Oberfläche aufweisenden Block, wobei das erste Linsenelement integraler Bestandteil des Blocks ist und ein erster Bereich der Oberfläche des Blocks eine Oberfläche des ersten Linsenelements bildet. Weiterhin ist die Apertur (als telezentrische Apertur) in Form einer ersten Spiegelfläche realisiert, welche an einem zweiten Bereich der Oberfläche des Blocks ausgebildet ist und bezüglich der optischen Achse des ersten Linsenelements geneigt ist.

Demnach sind alle Komponenten des optischen Systems, welche den Lauf von Lichtstrahlen durch das optische System (Strahlengang) zwischen der der Massskala zugewandten Oberfläche des ersten Linsenelements und dem Sensor zum Erfassen des Bildes der Massskala beeinflussen, Bestandteil eines einzigen (einstückigen) Blocks und an der Oberfläche dieses Blocks ausgebildet, beispielsweise als lichtbrechende Grenzfläche (z.B. als Linsenelement) oder als reflektierende Fläche (Spiegel).

Ein derartiger Block kann mit konventionellen Mitteln relativ einfach (z.B. in wenigen Arbeitsgängen) hergestellt werden, beispielsweise als Formteil mittels Spritzgiessen oder Spritzprägen von Kunststoff mithilfe entsprechender Formen, welche für eine Durchführung derartiger Verfahren geeignet sind. Folglich kann ein derartiger Block in grossen Stückzahlen kostengünstig hergestellt werden.

Der Messkopf der erfindungsgemässen Vorrichtung besteht demnach aus wenigen Komponenten und kann folglich mit geringem Aufwand montiert werden.

Dadurch, dass die telezentrische Apertur als Spiegelfläche ausgebildet ist, ist eine Voraussetzung dafür gegeben, dass das Linsenelement und die telezentrische Apertur in einen einzigen (einstückigen) und aus einem einzigen Werkstoff herstellbaren Körper integrierbar und in demselben Arbeitsschritt herstellbar sind. Zur Realisierung der telezentrischen Apertur muss im Falle der erfindungsgemässen Vorrichtung lediglich in einem bestimmten Bereich der Oberfläche desjenigen Körpers, welcher das Linsenelement umfasst, eine geeignet angeordnete Grenzfläche geschaffen werden, welche geeignet ist, das auf diese Grenzfläche einfallende Licht zu reflektieren. Zur Erhöhung der Reflektivität dieser Grenzfläche kann es gegebenenfalls zweckmässig sein, die Grenzfläche mit einer geeigneten Beschichtung zu versehen.

Im Unterschied hierzu müssen im Falle des aus US 7186969 B2 bekannten optischen Systems das Linsenelement und die telezentrische Apertur durch Bearbeiten verschiedener Werkstücke aus unterschiedlichen Materialien separat voneinander hergestellt werden und anschliessend auf eine vorgegebene Weise relativ zueinander angeordnet werden.

Im Vergleich zu dem aus US 7186969 B2 bekannten optischen System müssen im Falle des telezentrischen optischen Systems gemäss der Erfindung demnach weniger separate Komponenten montiert werden, sodass die Montage des optischen Systems gemäss der Erfindung offensichtlich mit geringerem Aufwand verbunden ist.

Dadurch, dass die telezentrische Apertur gemäss der Erfindung als Spiegelfläche ausgebildet ist, ist weiterhin eine Voraussetzung dafür gegeben, dass das telezentrische optische System gemäss der Erfindung relativ wenig Platz beansprucht. Wegen der Ausbildung der telezentrischen Apertur als Spiegelfläche kann nämlich die Erstreckung des Blocks in einer Richtung senkrecht zur Massskala im Wesentlichen auf eine Distanz beschränkt werden, welche der jeweiligen Brennweite des Linsenelements entspricht. Diejenigen Lichtstrahlen, welche in Richtung der optischen Achse des Linsenelements auf das Linsenelement treffen, werden nämlich an der (die telezentrische Apertur bildenden) ersten Spiegelfläche reflektiert, sodass sie sich längs der optischen Achse des Linsenelements nicht über die telezentrische Apertur hinaus ausbreiten können.

Im Falle des aus US 7186969 B2 bekannten optischen Systems ist hingegen die Erstreckung des optischen Systems in einer Richtung senkrecht zur Massskala wesentlich grösser als die Brennweite des jeweiligen Linsenelements und somit wesentlich grösser als die entsprechende Erstreckung eines telezentrischen optischen Systems gemäss der Erfindung bei gleicher Brennweite des jeweiligen Linsenelements.

Dadurch, dass die telezentrische Apertur gemäss der Erfindung als eine bezüglich der optischen Achse des ersten Linsenelements geneigte Spiegelfläche ausgebildet ist, wird erreicht, dass Lichtstrahlen, welche zur Erzeugung des jeweiligen Bildes der Massskala beitragen, einen Strahlengang aufweisen, welcher mindestens einfach gefaltet ist. Dadurch ist sichergestellt, dass das Bild der Massskala, welches mittels des telezentrischen optischen Systems erzeugt wird, in einem Raumbereich erzeugbar ist, welcher von dem Linsenelement und der telezentrischen Apertur getrennt ist. Dadurch ist gewährleistet, dass der Sensor zum Erfassen des Bildes der Massskala an einem Bereich der Oberfläche des Blocks platziert werden kann, welcher von dem Linsenelement und der telezentrischen Apertur räumlich getrennt ist, sodass der Sensor den Strahlengang nicht stört bzw. die Qualität des erzeugten Bildes der Massskala nicht beeinträchtigt.

Durch eine geeignete Wahl des Winkels, um den die erste Spiegelfläche relativ zur optischen Achse geneigt ist, kann weiterhin erreicht werden, dass das optische System auch in einer Richtung parallel zur Massskala möglichst wenig Platz beansprucht und das Volumen des Blocks dementsprechend minimiert werden kann. Letzteres gewährleistet einen kompakten Aufbau des telezentrischen optischen Systems gemäss der Erfindung.

Dementsprechend kann bei einer Ausführungsform der erfindungsgemässen Vorrichtung der Sensor an einem dritten Bereich der Oberfläche des Blocks angeordnet sein. Weiterhin kann die erste Spiegelfläche derart angeordnet sein, dass Licht entlang der optischen Achse derart durch das erste Linsenelement in den Block einkoppelbar ist, dass das jeweils eingekoppelte Licht an der ersten Spiegelfläche reflektiert wird und den Block am dritten Bereich der Oberfläche des Blocks verlässt. Der Block kann relativ zur Massskala derart angeordnet werden, dass das erste Linsenelement ein reelles Bild der Massskala (innerhalb vorgegebener Toleranzen) auf einer Oberfläche des Sensors erzeugt. Da die erste Spiegelfläche als telezentrische Apertur ausgebildet ist, tragen zu dem Bild der Massskala im Wesentlichen Lichtstrahlen bei, welche im Wesentlichen parallel zur optischen Achse auf das erste Linsenelement treffen. Diese Lichtstrahlen treffen in diesem Fall auf die erste Spiegelfläche und anschliessend - nach einer Reflexion an der ersten Spiegelfläche - auf den Sensor.

Eine Weiterentwicklung der vorstehend genannten Ausführungsform der erfindungsgemässen Vorrichtung zeichnet sich dadurch aus, dass an einem vierten Bereich der Oberfläche des Blocks eine oder mehrere zweite Spiegelflächen ausgebildet sind und die jeweiligen zweiten Spiegelflächen relativ zur ersten Spiegelfläche derart angeordnet sind, dass Licht entlang der optischen Achse derart durch das erste Linsenelement in den Block einkoppelbar ist, dass das jeweils eingekoppelte Licht an der ersten Spiegelfläche und anschliessend an mindestens einer der zweiten Spiegelflächen reflektiert wird und schliesslich den Block am dritten Bereich der Oberfläche verlässt. Bei dieser Ausführungsform werden Lichtstrahlen auf einem Weg zwischen dem Linsenelement und dem Sensor (welcher am dritten Bereich der Oberfläche des Blocks angeordnet ist) an mindestens zwei oder mehr als zwei Spiegelflächen reflektiert, wobei sich die Richtung des jeweiligen Lichtstrahls bei jeder Reflexion an der jeweiligen Spiegelfläche ändert. Die jeweiligen Spiegelflächen können beispielsweise derart angeordnet sein, dass Lichtstrahlen, welche zur Erzeugung des jeweiligen Bildes der Massskala beitragen, auf dem Weg zum Sensor zwischen gegenüberliegenden Seiten des Blocks ein oder mehrmals hin- und her reflektiert werden. Dadurch wird erreicht, dass Lichtstrahlen, welche zur Erzeugung des jeweiligen Bildes der Massskala beitragen, einen Strahlengang durch das optische System aufweisen, welcher mehrfach gefaltet ist. Dadurch ist eine Voraussetzung dafür geschaffen, dass das optische System besonders kompakt gebaut sein kann: Je häufiger der Strahlengang gefaltet ist, umso kleiner kann das Volumen des Blocks gewählt werden und umso weniger Platz wird von dem Block beansprucht. Allerdings ist zu beachten, dass die Anforderungen, welche die jeweiligen Spiegelflächen hinsichtlich ihrer optischen Qualität erfüllen müssen, mit der Anzahl der Faltungen des Strahlengangs zunehmen.

Eine Ausführungsform der erfindungsgemässen Vorrichtung umfasst eine Beleuchtungsvorrichtung mit mindestens einer Lichtquelle, mittels welcher mindestens ein Bereich der Massskala beleuchtbar ist, wobei dieser Bereich der Massskala derart angeordnet ist, dass mittels des telezentrischen optischen Systems ein Bild dieses Bereichs der Massskala erzeugbar und dieses Bild mit dem Sensor erfassbar ist. Eine derartige Lichtquelle kann beispielsweise derart neben dem Block angeordnet sein, dass das Licht, welches mittels der jeweiligen Lichtquelle erzeugbar ist, die Massskala bzw. den beleuchtbaren Bereich der Massskala auf einem Weg erreicht, welcher an dem Block vorbei führt, sodass dieses Licht die Massskala erreicht, ohne auf die Oberfläche des Blocks zu treffen. Durch diese Anordnung der Lichtquelle kann weitgehend verhindert werden, dass das Licht der Lichtquelle an der Oberfläche des Blocks gestreut und - ohne auf die Massskala zu treffen - den Sensor erreicht. Dadurch wird erreicht, dass das Bild, welches das optische System von dem von der Lichtquelle beleuchteten Bereich der Massskala erzeugt, einen hohen Kontrast aufweist. Als Lichtquelle ist beispielsweise eine Leuchtdiode (LED) geeignet.

In einer weiteren Variante der erfindungsgemässen Vorrichtung ist die jeweilige Lichtquelle der Beleuchtungsvorrichtung derart angeordnet, dass mittels der Lichtquelle erzeugtes Licht an einem Bereich der Oberfläche des Blocks in den Block einkoppelbar und an einem anderen Bereich der Oberfläche des Blocks auskoppelbar ist. In diesem Fall erreicht das Licht, welches mittels der jeweiligen Lichtquelle erzeugbar ist, die Massskala bzw. den beleuchtbaren Bereich der Massskala auf einem Weg, welcher durch den Block führt. Eine derartige Anordnung der jeweiligen Lichtquelle hat den Vorteil, dass die jeweilige Lichtquelle relativ weit entfernt von dem Bereich der Massskala angeordnet werden kann, welcher mithilfe der Lichtquelle beleuchtet werden soll. Die jeweilige Lichtquelle kann beispielsweise an einem Bereich der Oberfläche des Blocks platziert sein, welcher auf der von der Massskala abgewandten Seite des Blocks angeordnet ist. In diesem Fall ist die jeweilige Lichtquelle besonders einfach zugänglich, was beispielsweise die Montage der Lichtquelle erleichtert oder einen Austausch der Lichtquelle gegen eine andere Lichtquelle vereinfacht. Weiterhin bietet diese Anordnung der jeweiligen Lichtquelle die Möglichkeit, die Lichtquelle und den Sensor und gegebenenfalls weitere elektronische Komponenten als eine modulare Einheit auszubilden, welche als Ganzes an dem Block montiert werden kann. Letzteres vereinfacht die Montage derjenigen Komponenten des Messkopfes, welche einen Anschluss an eine Strom- bzw. Spannungsquelle benötigen.

In einer Weiterentwicklung der vorstehend genannten Variante der erfindungsgemässen Vorrichtung weist derjenige Bereich der Oberfläche des Blocks, an welchem das mittels der jeweiligen Lichtquelle der Beleuchtungsvorrichtung erzeugte Licht auskoppelbar ist, eine Krümmung auf, sodass dieser Bereich der Oberfläche ein Linsenelement bildet. Dieses Linsenelement bietet die Möglichkeit, die räumliche Verteilung der Intensität des Lichts, welches aus dem Block auskoppelbar ist, zu beeinflussen. Letztes dient einer Optimierung der räumlichen Verteilung der Intensität des mittels der Lichtquelle erzeugbaren Lichts im beleuchtbaren Bereich des Massskala. Das Linsenelement könnte beispielsweise so geformt und angeordnet sein, dass es das von der Lichtquelle erzeugte Licht kollimiert oder auf die Massskala fokussiert.

In einer Weiterentwicklung der vorstehend genannten Variante der erfindungsgemässen Vorrichtung ist an einem Bereich der Oberfläche des Blocks eine reflektierende Fläche ausgebildet, welche derart angeordnet ist, dass das jeweils in den Block eingekoppelte Licht der jeweiligen Lichtquelle der Beleuchtungsvorrichtung an dieser reflektierenden Fläche reflektiert wird. In diesem Fall wird die Möglichkeit genutzt, die Richtung der Ausbreitung des mittels der Lichtquelle erzeugten Lichts mittels eines Bereichs der Oberfläche des Blocks zu beeinflussen: Die räumliche Anordnung der Lichtquelle und des jeweiligen Bereichs der Oberfläche des Blocks können derart aufeinander abgestimmt werden, dass das Licht der Lichtquelle durch die Reflexion an dem jeweiligen Bereich der Oberfläche in die jeweils gewünschte Richtung gelenkt wird.

Eine weitere Variante der erfindungsgemässen Vorrichtung umfasst einen oder mehrere Lichtleiter, wobei die jeweiligen Lichtleiter derart angeordnet sind, dass mittels der jeweiligen Lichtquelle der Beleuchtungsvorrichtung erzeugtes Licht über einen der jeweiligen Lichtleiter in den Block einkoppelbar ist. Der Lichtleiter kann beispielsweise ein separates Bauteil sein und in einer in dem jeweiligen Block ausgebildeten Ausnehmung angeordnet sein. Alternativ kann der jeweilige Lichtleiter in den Block integriert sein. Der jeweilige Lichtleiter bietet eine weitere Möglichkeit, die räumliche Verteilung der Intensität des mittels der Lichtquelle erzeugten Lichts zu beeinflussen, insbesondere im Bereich der Oberfläche des Blocks, an dem das Licht aus dem Block ausgekoppelt wird. Der Lichtleiter kann insbesondere so ausgebildet sein, dass die räumliche Verteilung der Intensität des in den Block eingekoppelten Lichts im Wesentlichen unabhängig von der Länge des Lichtleiters ist. In diesem Fall kann sich demnach das von der jeweiligen Lichtquelle erzeugte Licht mithilfe des Lichtleiters über eine relativ grosse Distanz, z.B. bis in die Nähe der Massskala, geführt werden, ohne dass sich die räumliche Verteilung der Intensität des Lichts (gemessen innerhalb einer Ebene senkrecht zur Ausbreitungsrichtung des Lichts) entlang der Ausbreitungsrichtung des Lichts wesentlich verändert.

Eine Ausführungsform der erfindungsgemässen Vorrichtung umfasst eine Massskala, welche eine oder mehrere Inkrementalspuren mit jeweils mehreren inkremental angeordneten Markierungen und/oder eine oder mehrere Referenzspuren mit einer oder mehreren Referenz-Markierungen aufweist.

Eine Weiterentwicklung dieser Ausführungsform zeichnet sich dadurch aus, dass die Massskala eine Mehrzahl von Markierungen aufweist, welche in mehreren nebeneinander angeordneten Spuren angeordnet sind, und die Beleuchtungsvorrichtung mehrere Lichtquellen umfasst, welche Lichtquellen derart angeordnet sind, dass eine der Spuren mittels einer der jeweiligen Lichtquellen und eine andere der Spuren mittels einer anderen der jeweiligen Lichtquellen beleuchtet werden kann. Auf diese Weise können auch verschiedene Spuren von Markierungen, welche einen relativ grossen Abstand zueinander aufweisen, unabhängig voneinander so beleuchtet werden, dass die Markierungen selbst mit einer vorgegebenen (optimalen) Lichtintensität beleuchtet werden, während ein Zwischenraum zwischen den jeweiligen Spuren nicht beleuchtet oder nur mit einer relativ geringen Lichtintensität beleuchtet wird. Auf diese Weise kann die Energie, die zur Beleuchtung verschiedener Spuren benötigt wird, minimiert werden. Auf diese Weise wird auch vermieden, dass die Beleuchtungsvorrichtung übermässig viel Wärme generiert und gegebenenfalls wärmeempfindliche Komponenten in ihrer unmittelbaren Umgebung (z.B. den Sensor, andere elektronische Komponenten oder wärmeempfindliche Werkstoffe) beeinträchtigt oder beschädigt.

Eine Ausführungsform der erfindungsgemässen Vorrichtung zeichnet sich dadurch aus, dass die Massskala derart ausgebildet ist, dass ein Rand der jeweiligen Markierung an einen reflektierenden Flächenbereich angrenzt, welcher derart angeordnet ist, dass das mittels der jeweiligen Lichtquelle der Beleuchtungsvorrichtung erzeugte Licht an dem reflektierenden Flächenbereich derart reflektiert wird, dass das jeweils reflektierte Licht nicht auf das erste Linsenelement trifft. Weiterhin ist die jeweilige Markierung derart ausgebildet, dass an der Markierung, falls diese mittels der Beleuchtungsvorrichtung beleuchtet ist, Streulicht erzeugt wird, welches durch das erste Linsenelement in den Block eindringen kann. Falls die Massskala unter der vorstehend genannten Voraussetzung mittels der jeweiligen Lichtquelle der Beleuchtungsvorrichtung beleuchtet wird, dann ist der Beitrag des von der jeweiligen Markierung erzeugten Streulichts zur Intensität des Lichts, welches insgesamt durch das erste Linsenelement dringt, relativ gross (insbesondere im Vergleich zu dem entsprechenden Beitrag von Licht, welches gegebenenfalls an dem reflektierenden Flächenbereich in Richtung auf das erste Linsenelement gestreut werden könnte). Dadurch wird erreicht, dass das optische System von dem Bereich der Massskala, welcher mittels der Beleuchtungsvorrichtung beleuchtet wird, jeweils ein Bild erzeugt, in welchem der jeweilige reflektierende Flächenbereich im Vergleich zu der jeweiligen Markierung relativ dunkel erscheint, bzw. in welchem die jeweilige Markierung im Vergleich zu dem an die Markierung angrenzenden reflektierenden Flächenbereich relativ hell erscheint. In diesem Fall ist demnach eine "Dunkelfeld"-Beleuchtung realisiert, welche es ermöglicht, ein besonders kontrastreiches Bild der jeweiligen Markierungen zu erzeugen.

Eine Ausführungsform der erfindungsgemässen Vorrichtung zeichnet sich dadurch aus, das zwischen der jeweiligen Lichtquelle der Beleuchtungsvorrichtung und dem Block ein Blendenkörper angeordnet ist, welcher für Licht der jeweiligen Lichtquelle nicht transparent ist. Der Blendenkörper kann derart angeordnet bzw. geformt sein, dass das mittels der jeweiligen Lichtquelle erzeugte Licht den Sensor nicht erreichen kann, es sei denn, es beleuchtet einen vorgegebenen Bereich der Massskala derart, dass das an den jeweils beleuchteten Markierungen erzeugte Streulicht auf das erste Linsenelement trifft, während der Teil des Lichts, welcher an der Massskala reflektiert wird, nicht auf das erste Linsenelement treffen kann. Der Blendenkörper kann als Träger für den Block und die Beleuchtungsvorrichtung ausgebildet sein. Zu diesem Zweck kann der Blendenkörper beispielsweise einstückig ausgebildet sein und zwei getrennte Kammern aufweisen, wobei eine der Kammern zur Aufnahme der Blocks und die andere Kammer zur Aufnahme der Beleuchtungsvorrichtung dient. Die beiden Kammern können jeweils an einer der Massskala zugewandten Seite eine Öffnung aufweisen, sodass einerseits ein vorgegebener Bereich Massskala durch eine dieser Öffnungen mittels der Beleuchtungsvorrichtung beleuchtet werden kann, während das jeweils an den Markierungen gestreute Licht aus dem beleuchteten Bereich der Massskala durch die andere Öffnung zum ersten Linsenelement gelangen kann.

Die erfindungsgemässe Vorrichtung zur Bestimmung einer Position kann auch in Kombination mit einem Führungssystem verwendet werden, welches einen ersten Körper und einen relativ zum ersten Körper bewegbaren, an dem ersten Körper geführten zweiten Körper aufweist. Die Massskala der erfindungsgemässen Vorrichtung kann beispielsweise ortsfest bezüglich des ersten Körpers und der Messkopf der erfindungsgemässen Vorrichtung ortsfest bezüglich des zweiten Körpers angeordnet sein. Das Führungssystem kann beispielsweise eine Linearführung oder eine Drehführung sein.

Weitere Einzelheiten der Erfindung und insbesondere beispielhafte Ausführungsformen der erfindungsgemässen Vorrichtung werden im Folgenden anhand der beigefügten Zeichnungen erläutert. Es zeigen:
Fig. 1 eine perspektivische Darstellung eines Führungssystems in Form einer Linearführung, mit einem ersten Körper in Form einer Führungsschiene, mit einem zweiten Körper in Form eines an der Führungsschiene geführten Führungswagens und mit einer erfindungsgemässen Vorrichtung zur Bestimmung einer Position, welche Vorrichtung eine Massskala und einen Messkopf zum optischen Abtasten der Massskala umfasst;
Fig. 2 eine perspektivische Darstellung eines Abschnitts der Führungsschiene und eines Abschnitts der Massskala gemäss Fig. 1;
Fig. 3 den Führungswagen gemäss Fig. 1, wobei jedoch der Messkopf entfernt ist und eine Ausnehmung zur Aufnahme des Messkopfes erkennbar ist;
Fig. 4 eine schematische Darstellung des Messkopfes gemäss Fig. 1 aus einer anderen Perspektive;
Fig. 5 eine erste Ausführungsform der erfindungsgemässen Vorrichtung zur Bestimmung einer Position gemäss Fig. 1, in einem Schnitt in Längsrichtung der Führungsschiene dargestellt, mit einem telezentrischen optischen System gemäss der Erfindung und einer ersten Ausführungsform einer Beleuchtungsvorrichtung zur Beleuchtung eines Bereichs der Massskala;
Fig. 6A, 6B einen Teil des telezentrischen optischen Systems gemäss Fig. 5 (Fig. 6A) und einen Teil eines telezentrischen optischen Systems gemäss dem Stand der Technik (Fig. 6B);
Fig. 7 einen Schnitt durch die Führungsschiene und die Massskala gemäss Fig. 1 und eine schematische Darstellung einer Beleuchtung der Massskala und einer Wirkung der Beleuchtung;
Fig. 8 eine schematische Darstellung (Blockschaltbild) eines Sensors des Messkopfs gemäss Fig. 1;
Fig. 9 eine schematische Darstellung eines Teils des Sensors gemäss Fig. 8 beim Erfassen eines mit dem telezentrischen optischen System gemäss Fig. 5 erzeugten Bildes der Massskala;
Fig. 10 eine zweite Ausführungsform der erfindungsgemässen Vorrichtung zur Bestimmung einer Position gemäss Fig. 1, mit einem telezentrischen optischen System gemäss Fig. 5, jedoch mit einer anderen (zweiten) Ausführungsform der Beleuchtungsvorrichtung zur Beleuchtung eines Bereichs der Massskala;
Fig. 11 eine dritte Ausführungsform der erfindungsgemässen Vorrichtung zur Bestimmung einer Position gemäss Fig. 1, mit einem telezentrischen optischen System gemäss Fig. 5, jedoch mit einer anderen (dritten) Ausführungsform der Beleuchtungsvorrichtung zur Beleuchtung eines Bereichs der Massskala.

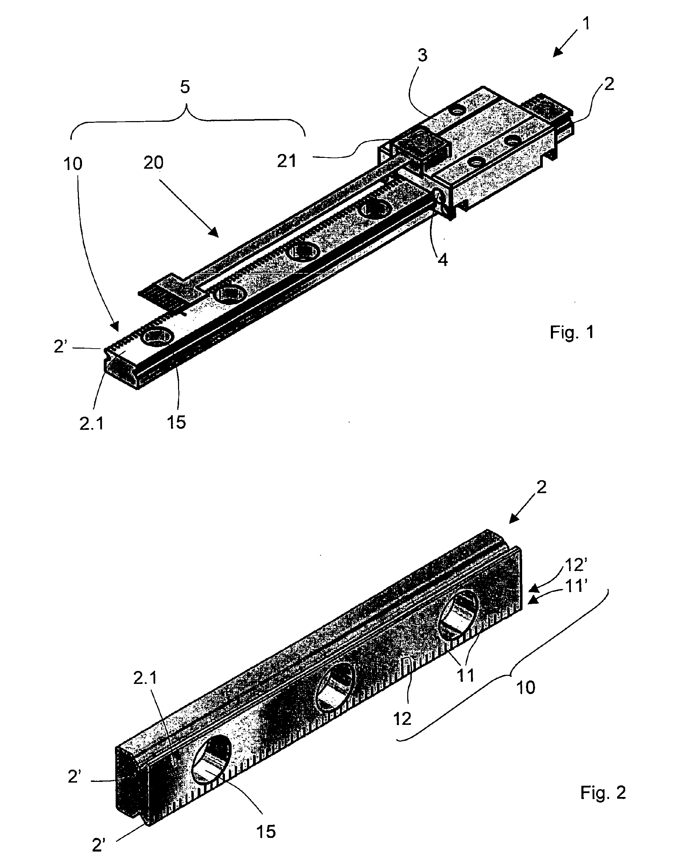

Figur 1 zeigt ein Linearführungssystem 1 mit einer geraden Führungsschiene 2, einem auf der Führungsschiene 2 angeordneten und längs der Führungsschiene 2 bewegbaren Führungswagen 3 und einer ersten Ausführungsform einer erfindungsgemässen Vorrichtung 5 zum Bestimmen einer Position des Führungswagens 3 bezüglich der Führungsschiene 2.

Der Führungswagen 3 ist auf der Führungsschiene 2 über (in den Figuren nicht dargestellte) Wälzkörper abgestützt, welche in mehreren im Führungswagen 3 ausgebildeten Kanälen 4 derart angeordnet sind, dass sie sich in dem jeweiligen Kanal 4 relativ zur Führungsschiene 2 bzw. relativ zum Führungswagen 3 bewegen, falls der Führungswagen 3 entlang der Führungsschiene 2 bewegt wird.

Die Vorrichtung 5 umfasst eine Massskala 10 und eine Abtastvorrichtung 20 mit einem Messkopf 21 zum optischen Abtasten der Massskala 10.

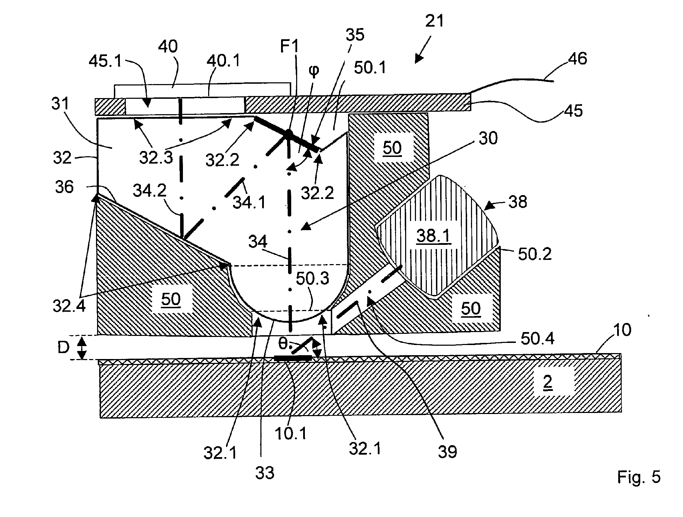

Wie Fig. 1 und 2 zeigen, ist die Massskala 10 auf einer dem Führungswagen 3 zugewandten (oberen) Fläche 2.1 der Führungsschiene 2 und insbesondere an einem Rand 2' der Führungsschiene 2 ausgebildet. Im zentralen Bereich der Führungsschiene 2 sind Löcher 15 zum Befestigen der Führungsschiene 2 an hier nicht dargestellten Montageelementen vorhanden. Die Massskala 10 beansprucht Platz im wesentlichen in einem streifenförmigen Flächenbereich zwischen dem Rand 2' und den Löchern 15 und kann deshalb als lineare Massskala ausgebildet sein, die sich (ohne Unterbrechung) über die gesamte Länge der Führungsschiene 2 erstreckt. Die Massskala 10 ist im vorliegenden Ausführungsbeispiel derart ausgebildet, dass ein optischer Sensor sie abzutasten vermag (was im Folgenden im Zusammenhang mit Fig. 5 und 7-9 noch näher erläutert wird).

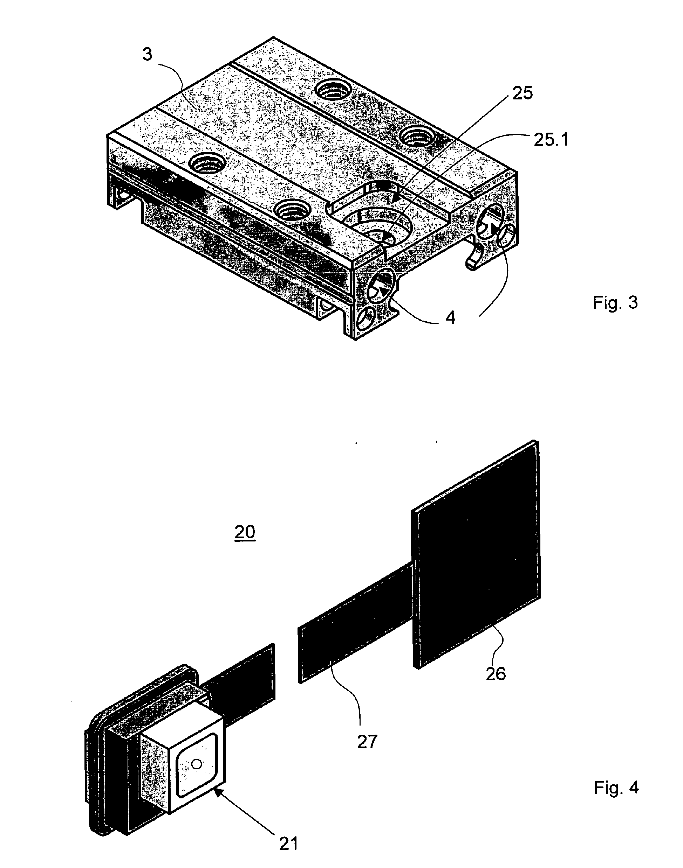

Fig. 3 zeigt den Führungswagen 3 im Detail (ohne die Wälzkörper und Führungen für die Wälzkörper). Der Führungswagen 3 ist in einer herkömmlichen Weise ausgebildet. Auf der Oberseite des Führungswagens 3 ist eine Ausnehmung 25 vorhanden, die zur Aufnahme des Messkopfes 21 dient. Um eine optische Abtastung der Massskala 10 mit dem Messkopf 21 zu ermöglichen, umfasst die Ausnehmung 25 eine durch den Führungswagen 3 durchgehende Bohrung 25.1, welche oberhalb der Massskala 10 derart ausgebildet ist, dass ein Abschnitt der Massskala 10 durch die Bohrung 25.1 mit optischen Mitteln abtastbar ist. Die Bohrung 25.1 wird möglichst klein gehalten, um für eine hohe mechanische Stabilität des Führungswagens 3 zu sorgen.

Fig. 4 zeigt Einzelheiten der Abtastvorrichtung 20. Diese umfasst den Messkopf 21 und eine Versorgungseinrichtung 26, welche über ein Kabel 27 (oder alternativ mit einer Leiterplatte) mit dem Messkopf 21 verbunden ist und zusätzlich an eine (nicht dargestellte) Kontrolleinheit angeschlossen werden kann, um einerseits eine Versorgung des Messkopfes 21 mit Energie zu gewährleisten und einen Austausch von Steuer- und Messsignalen zwischen dem Messkopf 21 und der Kontrolleinheit zu ermöglichen.

Wie Fig. 2 zeigt, umfasst die Massskala 10 eine parallel zum Rand 2' der Fläche 2.1 verlaufende Inkrementalspur 11' mit einer Vielzahl von (äquidistanten) Markierungen 11 und eine Referenzspur 12' mit Referenz-Markierungen 12. Im vorliegenden Fall sind die Referenz-Markierungen 12 neben der Inkrementalspur 11' angeordnet. Die Markierungen 11 und die Referenz-Markierungen 12 sind im vorliegenden Beispiel jeweils geradlinige Strukturen, deren Längsachsen senkrecht zur Längsrichtung der Führungsschiene 2 und somit senkrecht zur Längsrichtung der Spuren 11' und 12' angeordnet sind. Der Messkopf 21 ist dabei so am Führungswagen 3 angeordnet, dass sowohl die Markierungen 12 der Referenzspur 12' als auch die Markierungen 11 der Inkrementalspur 11' vom Messkopf 21 abgetastet werden können, wenn der Führungswagen 3 entlang der Führungsschiene 2 bewegt wird.

Die Markierungen 11 und 12 können auf der Fläche 2.1 beispielsweise durch eine Bearbeitung der Fläche 2.1 mittels Laserstrahlen erzeugt werden (wie aus WO 2005/033621 A1 bekannt). Auf diese Weise erzeugte Markierungen 11 der Inkrementalspur 11' können beispielsweise so dimensioniert sein, dass sich eine Markierung 11 in der Längsrichtung der Inkrementalspur 11' beispielsweise 5 µm erstreckt und die jeweiligen Markierungen 11 entlang der Inkrementalspur 11' in Abständen von ca. 10 µm angeordnet sind.

Im vorliegenden Fall ist eine Referenz-Markierung 12 im zentralen Bereich der Führungsschiene 2 (in etwa in der Mitte) zwischen zwei Löchern 15 angeordnet. Diese Anordnung ist insbesondere zweckmässig bei schmalen Führungsschienen 2, die nicht wesentlich breiter sind als der Durchmesser der Löcher 15 und dementsprechend wenig Platz für die Anordnung der Massskala 10 bieten.

Fig. 5 zeigt die Vorrichtung 5 gemäss Fig. 1 in einem Schnitt in Längsrichtung der Führungsschiene 2, wobei lediglich der Messkopf 21 und die Führungsschiene 2 einschliesslich der Massskala 10 dargestellt sind. Wie ersichtlich, ist der Messkopf 21 in einem Abstand D zur Massskala 10 angeordnet.

Der Messkopf 21 umfasst u.a.:
- ein telezentrisches optisches System 30 zur Erzeugung eines Bildes der Massskala 10,
- einen Sensor 40, welcher das jeweils mittels des telezentrischen optischen Systems 30 erzeugte Bild erfasst und Signale bereitstellt, welche eine Registrierung von Markierungen 11 und/oder 12 der Massskala 10 und eine Bestimmung der Position des Messkopfes 21 relativ zur Massskala 10 ermöglichen und
- eine Beleuchtungsvorrichtung 38 zur Beleuchtung der Massskala 10.

Ausgangssignale des Messkopfes 21 können von der Kontrolleinheit schliesslich in Daten umgesetzt werden, die einen von dem Führungswagen 3 bezüglich der Führungsschiene 2 zurückgelegten Weg und/oder die momentane Position des Führungswagens 3 bezüglich der Führungsschiene 2 angeben.

Das telezentrische optische System 30 umfasst ein in einem Abstand zur Massskala 10 angeordnetes erstes Linsenelement 33, welches ortsfest relativ zum Sensor 40 derart angeordnet ist, dass das Linsenelement 33 ein reelles Bild eines Bereichs der Massskala 10 auf einer der Massskala 10 zugewandten Oberfläche 40.1 des Sensors 40 erzeugt. Wie Fig. 5 andeutet, ist die der Massskala 10 zugewandte Oberfläche des Linsenelements 33 im vorliegenden Beispiel konvex gekrümmt und weist eine optische Achse 34 auf, welche im Wesentlichen senkrecht zur Führungsschiene 2 angeordnet ist.

Wie Fig. 5 weiterhin andeutet, ist das erste Linsenelement 33 integraler Bestandteil eines (einstückigen) Blocks 31, welcher eine Oberfläche 32 aufweist, wobei ein erster (in Fig. 5 durch Pfeile 32.1 gekennzeichneter) Bereich 32.1 der Oberfläche 32 des Blocks 31 eine Oberfläche des ersten Linsenelements 33 bildet.

Das Linsenelement 33 ist derart ausgebildet, dass es auf der der Massskala 10 abgewandten Seite einen Fokus F1 aufweist, welcher in einem zweiten (in Fig. 5 durch Pfeile 32.2 gekennzeichneten) Bereich 32.2 der Oberfläche 32 des Blocks 31 liegt. Demnach wird Licht, welches von der der Massskala 10 zugewandten Seite des Linsenelements 33 her parallel zur optischen Achse 34 auf das Linsenelement 33 trifft, durch das Linsenelement 33 auf den Fokus F1 fokussiert. Im vorliegenden Fall ist der Oberflächenbereich 32.2 als eine erste Spiegelfläche 35 ausgebildet, welche bezüglich der optischen Achse 34 des Linsenelements 33 um einen Winkels ϕ (<90°) geneigt ist.

Wie Fig. 5 andeutet, ist der Sensor 40 im vorliegenden Beispiel an einem (durch Pfeile 32.3 gekennzeichneten) dritten Bereich 32.3 der Oberfläche 32 des Blocks 31 platziert. Der Bereich 32.3 der Oberfläche 32 liegt auf der von der Massskala 10 abgewandten Seite des Blocks 31 neben dem zweiten Bereich 32.2 bzw. neben der ersten Spiegelfläche 35.

Wie Fig. 5 weiterhin andeutet, weist der Block 31 auf einer der Massskala 10 zugewandten Seite einen (durch Pfeile 32.4 gekennzeichneten) vierten Bereich 32.4 der Oberfläche 32 auf, welcher eine zweite Spiegelfläche 36 bildet. Der vierte Bereich 32.4 ist neben dem ersten Bereich 32.1 bzw. neben dem ersten Linsenelement 33 angeordnet.

Die erste Spiegelfläche 35 und die zweite Spiegelfläche 36 sind im vorliegenden Beispiel derart angeordnet, dass Licht, welches entlang der optischen Achse 34 durch das erste Linsenelement 33 in den Block 31 einkoppelt wird und dementsprechend die erste Spiegelfläche 35 erreicht, zunächst an der ersten Spiegelfläche 35 und anschliessend an der zweiten Spiegelfläche 36 reflektiert wird und schliesslich den Block 31 am dritten Bereich 32.3 der Oberfläche 32 verlässt und anschliessend auf die Oberfläche 40.1 des Sensors 40 trifft. Zur Veranschaulichung dieses Sachverhalts zeigt Fig. 5 beispielsweise den Lauf eines Lichtstrahls, welcher auf der optischen Achse 34 auf das Linsenelement 33 trifft: Dieser Lichtstrahl trifft zunächst am Fokus F1 auf die erste Spiegelfläche 35, läuft nach einer Reflexion an der ersten Spiegelfläche entlang der gestrichelten Linie 34.1 zur zweiten Spiegelfläche 36 und läuft nach einer weiteren Reflexion an der zweiten Spiegelfläche 36 entlang der gestrichelten Linie 34.2 zum dritten Oberflächenbereich 32.3 und trifft anschliessend nach einem Austritt aus dem Block 32 auf den Sensor 40. Demnach ist der Strahlengang des Lichtstrahls sowohl an der ersten Spiegelfläche 35 als auch an der zweiten Spiegelfläche 36 (d.h. insgesamt zweimal) gefaltet.

Die Spiegelfläche 35 schränkt einen Lauf von Lichtstrahlen durch das optische System (Strahlengang) derart ein, dass von denjenigen Lichtstrahlen, welche von der der Massskala 10 zugewandten Seite des Linsenelements 33 her auf das Linsenelement 33 treffen, lediglich solche Lichtstrahlen die Oberfläche 40.1 des Sensors 40 erreichen können, welche bei einem Lauf durch den Block 31 auf die Spiegelfläche 35 treffen. Da die Spiegelfläche 35 am Fokus F1 des Linsenelements 33 angeordnet ist, hat die Spiegelfläche 35 die Wirkung einer telezentrischen Apertur. Der äussere Rand der Spiegelfläche 35 (in Fig. 5 durch zwei Pfeile 32.2 markiert) bestimmt dabei die Grösse dieser Apertur.

Die Beleuchtungsvorrichtung 38 des Messkopfes 21 umfasst im vorliegenden Beispiel eine Lichtquelle 38.1, mittels welcher ein Bereich 10.1 der Massskala 10 beleuchtbar ist. Als Lichtquelle ist beispielsweise eine Leuchtdiode (LED) geeignet. Wie Fig. 5 andeutet, verläuft die optische Achse 34 des Linsenelements 33 durch das Zentrum des Bereichs 10.1, sodass gewährleistet ist, dass mittels des telezentrischen optischen Systems 30 ein Bild des Bereichs 10.1 der Massskala 10 erzeugbar und dieses Bild mit dem Sensor 40 erfassbar ist.

Die Lichtquelle 38.1 ist neben dem Block 31 derart angeordnet, dass das mittels der Lichtquelle 38.1 erzeugte Licht unter einem Winkel θ <90° auf den Bereich 10.1 der Massskala 10 fällt (die gestrichelte Linie 39 in Fig. 5 gibt die Richtung eines mittels der Lichtquelle 38.1 erzeugbaren Lichtstrahls an). Der Winkel θ ist im vorliegenden Fall so gewählt, dass der Teil des Lichts, welcher auf den Bereich 10.1 der Massskala 10 trifft und dort gerichtet reflektiert wird, nicht auf das Linsenelement 33 trifft und somit nicht den Sensor 40 erreichen kann. Auf diese Weise ist gewährleistet, dass allenfalls ein Teil des Lichts, welcher auf den Bereich 10.1 der Massskala 10 trifft und von dort diffus (im Wesentlichen parallel zur optischen Achse 34) gestreut wird, auf das Linsenelement 33 trifft und somit den Sensor 40 erreichen kann.

Wie Fig. 5 zeigt, umfasst der Messkopf 21 einen Blendenkörper 50, welcher für das mittels der Lichtquelle 38.1 erzeugbare Licht nicht transparent ist und zwischen der Lichtquelle 38.1 und dem Block 31 angeordnet ist, um zu verhindern, dass unerwünschtes Streulicht den Sensor 40 erreichen kann.

Im vorliegenden Beispiel dient der Blendenkörper 50 als Träger für den Block 31, die Beleuchtungsvorrichtung 38 und den Sensor 40. Zu diesem Zweck weist der Blendenkörper 50 eine erste Kammer 50.1, in welcher der Block 31 platziert ist bzw. platziert werden kann, und eine zweite Kammer 50.2, in welcher die jeweilige Lichtquelle 38.1 der Beleuchtungsvorrichtung 38 platziert ist bzw. platziert werden kann, auf.

Die zweite Kammer 50.2 weist auf einer der Massskala 10 zugewandten Seite eine Öffnung 50.4 auf, welche derart angeordnet ist, dass der Bereich 10.1 der Massskala 10 mittels der Lichtquelle 38.1 der Beleuchtungsvorrichtung 30 durch diese Öffnung 50.4 der zweiten Kammer beleuchtbar ist. Entsprechend weist die erste Kammer 50.1 auf einer der Massskala zugewandten Seite eine Öffnung 50.3 auf, welche derart angeordnet ist, dass das telezentrische optische System 30 das jeweilige Bild des Bereichs 10.1 der Massskala 10 durch diese Öffnung 50.3 der ersten Kammer 50.1 erzeugen kann.

Wie Fig. 5 weiterhin zeigt, ist der Sensor 40 an einer elektronischen Leiterplatte 45 befestigt, welche einerseits als Träger für den Sensor 40 dient und ausserdem mit verschiedenen (in Fig. 5 nicht dargestellten) elektrischen bzw. elektronischen Komponenten bestückt ist, beispielsweise mit (i) einer Spannungsversorgung des Sensors, (ii) einer elektronischen Schaltung zur Aufbereitung von Signalen des Sensors, (iii) einer Stromversorgung für die Lichtquelle 38.1 der Beleuchtungsvorrichtung 38, (iv) einer Regelung für die Beleuchtungsstärke der Lichtquelle 38.1 und (v) einer Schnittstelle, welche eine Verbindung zwischen den erwähnten elektrischen bzw. elektronischen Komponenten auf der Leiterplatte 45 und der Kontrolleinheit über Leitungen 46 gewährleistet, um einen Austausch von Signalen und/oder Daten über die Leitungen 46 zu ermöglichen.

Wie Fig. 5 andeutet, ist die Leiterplatte 45 im vorliegenden Beispiel auf der von der Massskala 10 abgewandten Seite des Blocks 31 angeordnet und im Wesentlichen parallel zum dritten Bereich 32.3 der Oberfläche 32 des Blocks 31 ausgerichtet. Der Sensor 40 ist auf einer von dem Block 31 abgewandten Seite der Leiterplatte 45 angeordnet. Um zu ermöglichen, dass Licht, welches den Block 31 durchläuft und im Bereich 32.3 der Oberfläche 32 aus dem Block 31 austritt, die Oberfläche 40.1 des Sensors 40 erreichen kann, umfasst die Leiterplatte 45 in einem dem dritten Bereich 32.3 der Oberfläche 32 des Blocks 31 gegenüber liegenden Abschnitt ein durchgehendes Loch 45.1, sodass die Oberfläche 40.1 des Sensors 40 für das jeweilige Licht durch das Loch 45.1 zugänglich ist.

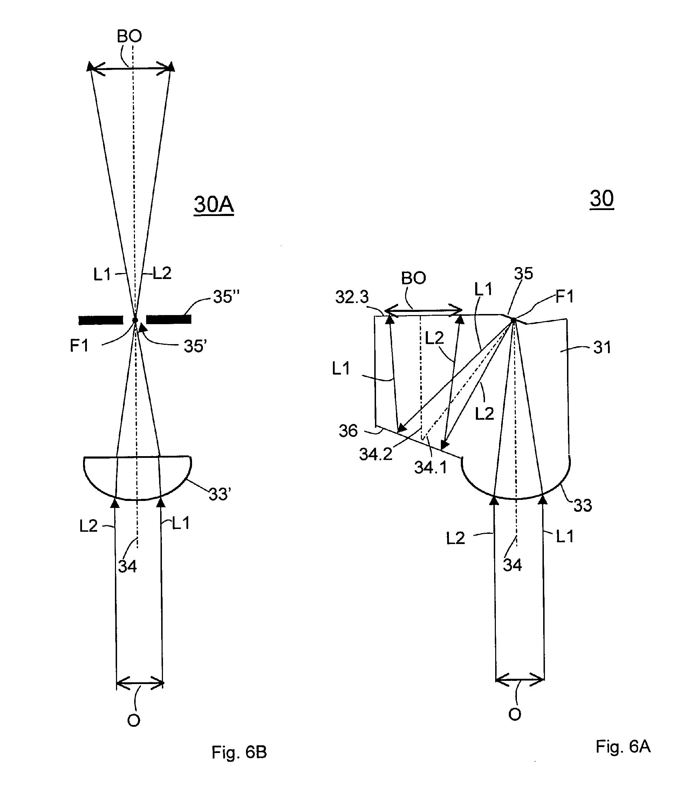

Fig. 6A und 6B bieten einen Vergleich zwischen den Eigenschaften eines telezentrischen optischen Systems gemäss der Erfindung und einem entsprechenden telezentrischen optischen System gemäss dem Stand der Technik.

Fig. 6A zeigt das telezentrische optische System 30 gemäss Fig. 5 in Kombination mit einem Objekt O (im vorliegenden Beispiel ein Doppelpfeil), welches auf der optischen Achse 34 in einem Abstand zum Linsenelement 33 auf der von der ersten Spiegelfläche 35 abgewandten Seite des Blocks 31 angeordnet ist, wobei der genannte Abstand derart gewählt ist, dass das telezentrische System 30 ein (vergrössertes) reelles Bild BO des Objekts O am dritten Bereich 32.3 der Oberfläche des Blocks 31 erzeugt. Fig. 6A zeigt weiterhin den Verlauf (Strahlengang) von zwei Lichtstrahlen L1 und L2, welche vom Objekt O ausgehen und durch das telezentrische optische System 30 zum Bild BO laufen. Im vorliegenden Beispiel verlaufen die Lichtstrahlen L1 und L2 - ausgehend vom Objekt O - auf einem Weg zum Linsenelement 33 zunächst parallel zur optischen Achse 34 und treffen auf das Linsenelement 33. Wie aus Fig. 6A ersichtlich, ändern die Lichtstrahlen L1 und L2 beim Eintritt in den Block 31 am Linsenelement 33 ihre Richtung derart, dass sie am Fokus F1 des Linsenelements 33 auf die erste Spiegelfläche 35 treffen und nach einer Reflexion an der ersten Spiegelfläche 35 und einer Reflexion an der zweiten Spiegelfläche 36 zum Bild BO gelangen. Da der Verlauf der Strahlen L1 und L2 im Block 31 zwischen der ersten Spiegelfläche 35 und dem Bild BO zweifach gefaltet ist, entsteht das Bild BO in einem relativ geringen Abstand bezüglich der Oberfläche des Linsenelements 33, welche dem Objekt O zugewandt ist.

Fig. 6B zeigt das Objekt O gemäss Fig. 6A in Kombination mit einem konventionellen telezentrischen optischen System 30A, welches beispielsweise aus US 7186969 B2 bekannt ist. In Fig. 6A und 6B sind identische Gegenstände jeweils mit identischen Bezugszeichen gekennzeichnet. Das telezentrische optische System 30A umfasst ein Linsenelement 33' mit einer optischen Achse 34 und einem Fokus F1 und eine telezentrische Apertur in Form einer Öffnung 35', welche in einer lichtundurchlässigen Blende 35" ausgebildet und auf der optischen Achse 34 am Fokus F1 auf der vom Objekt O abgewandten Seite des Linsenelements 33' angeordnet ist. Um einen Vergleich mit der Situation gemäss Fig. 6A zu ermöglichen, wird angenommen, dass das Objekt O im Falle der Fig. 6B auf der optischen Achse 34 angeordnet ist und eine Distanz zum Linsenelement 33' aufweist, welche identisch mit dem Abstand zwischen dem Objekt O und dem Linsenelement 33 gemäss Fig. 6A ist. Weiterhin wird angenommen, dass das Linsenelement 33' dieselbe Brennweite hat wie das Linsenelement 33 gemäss Fig. 6A. Dementsprechend hat der Fokus F1 im Falle der Fig. 6B denselben Abstand vom Objekt O wie der Fokus F1 gemäss Fig. 6A vom Objekt O gemäss Fig. 6. Wie aus Fig. 6B ersichtlich, erzeugt das telezentrische optische System 30A unter den genannten Voraussetzungen ein reelles Bild BO des Objekts O, welches dieselbe Grösse aufweist wie das Bild BO gemäss Fig. 6A. Im Falle des telezentrischen optischen Systems 30A wird das Bild BO auf der von dem Linsenelement 33*'* abgewandten Seite der Blende 35" erzeugt, wobei das Bild BO einen Abstand zu der Blende 35" aufweist, welcher umso grösser ist, je grösser das Bild BO im Vergleich zum Objekt O ist.

Um das jeweilige Bild BO mit einem Sensor mit grösstmöglicher Ortsauflösung abtasten zu können, müsste der jeweilige Sensor im Falle der telezentrischen optischen Systeme 30 und 30A jeweils an dem Ort platziert werden, an dem das jeweilige optische System 30 bzw. 30A das jeweilige Bild BO erzeugt. Wie aus Fig. 6A und 6B ersichtlich, kann der jeweilige Sensor zum Abtasten des Bildes BO im Falle des telezentrischen optischen Systems 30 in einem Abstand zum Linsenelement 33 angeordnet werden, der wesentlich kleiner ist als der Abstand zwischen dem Linsenelement 33' in Fig. 6B und dem Ort, an dem im Falle des telezentrischen optischen Systems 30A ein entsprechender Sensor zum Abtasten des Bildes BO angeordnet werden müsste. Ein Messkopf 21, bestehend aus dem telezentrischen optischen System 30 und einem Sensor 40 zum Abtasten des von diesem optischen System 30 erzeugten Bildes, kann dementsprechend wesentlich kleiner gebaut sein als ein entsprechender Messkopf, bestehend aus dem telezentrischen optischen System 30A und einem Sensor zum Abtasten des von diesem optischen System 30A erzeugten Bildes. Letzteres gilt insbesondere im Hinblick auf die Erstreckung des Messkopfes 21 in Richtung der optischen Achse.

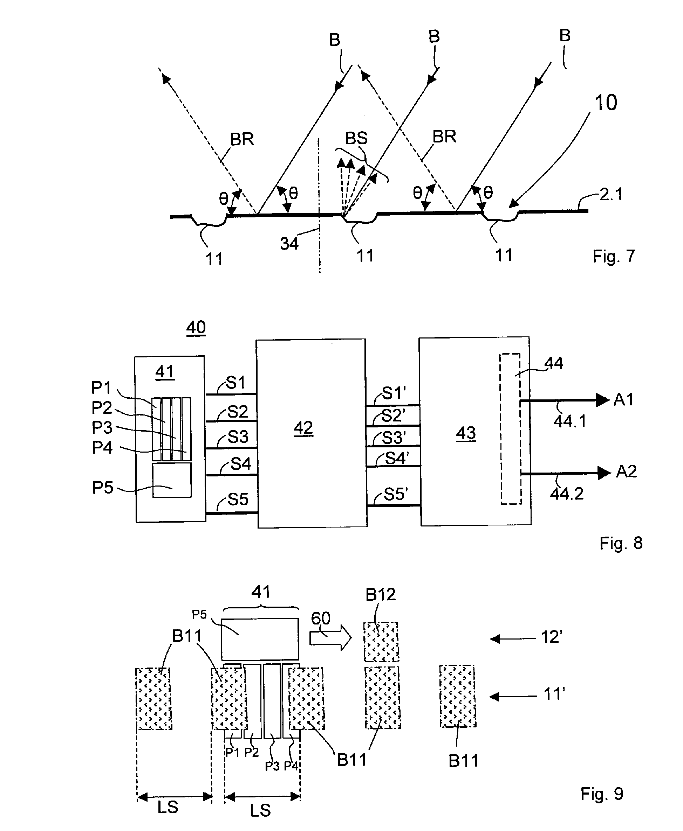

Fig. 7 zeigt ein Höhenprofil der Oberfläche 2.1 der Führungsschiene 2 im Bereich der Massskala 10 gemäss einem Schnitt senkrecht zur Oberfläche 2.1 in Längsrichtung der Führungsschiene 2 und illustriert den Effekt einer Beleuchtung der Oberfläche 2.1 der Führungsschiene 2 im Bereich der Massskala 10 mittels der Beleuchtungsvorrichtung 38 gemäss Fig. 5. Die Pfeile B in Fig. 7 geben die Richtung von Lichtstrahlen an, welche die Ausbreitung des auf die Massskala 10 einfallenden, mittels der Beleuchtungsvorrichtung 38 erzeugbaren Lichts charakterisieren. Im Folgenden wird davon ausgegangen, dass die Führungsschiene 2 eine typische (z.B. aus Stahl gefertigte) Führungsschiene eines Linearführungssystems gemäss dem Stand der Technik ist. Dementsprechend ist die Oberfläche 2.1 eine im Wesentlichen ebene Fläche, welche beispielsweise mittels Schleifen und/oder Fräsen bearbeitet ist und gegebenenfalls mittels Polieren nachbearbeitet sein kann. Die Markierungen 11 bzw. die Referenz-Markierungen 12 der Massskala 10 sind im vorliegenden Beispiel direkt auf eine Oberfläche der jeweiligen Führungsschiene 2 aufgebracht und können beispielsweise durch eine lokale Bearbeitung der jeweiligen Oberfläche mittels Laserstrahlen erzeugt werden. Wie aus WO 2005/033621 bekannt, hat eine Bearbeitung eines Teilbereichs einer Oberfläche der vorstehend genannten Art mittels Laserstrahlen den Effekt, dass sich einerseits im bearbeiteten Teilbereich (im Vergleich zu dem nicht bearbeiteten Bereich der Oberfläche) eine Vertiefung bildet. Weiterhin führt die Bearbeitung der jeweiligen Oberfläche mittels Laserstrahlen zu einer Änderung ihrer Eigenschaften hinsichtlich einer Reflexion von Licht: Die Bereiche der Oberfläche, welche nicht mittels Laserstrahlen bearbeitet sind, verhalten sich wie ein ebener Spiegel, welcher unter einem bestimmten (Einfalls-) Winkel θ bezüglich der Oberfläche einfallende Lichtstrahlen derart gerichtet reflektiert, dass sich das jeweils reflektierte Licht in eine Richtung unter einem (Reflexions-) Winkel bezüglich der Oberfläche ausbreitet, welcher gleich dem (Einfalls-) Winkel θ ist (Reflexionsgesetz); die mittels Laserstrahlen bearbeiteten Teilbereiche der Oberfläche verursachen hingegen keine oder nur eine geringe gerichtete Reflexion des einfallenden Lichts, sondern verursachen hauptsächlich eine diffuse Reflexion des einfallenden Lichts, d.h. die jeweiligen Teilbereiche streuen gerichtet einfallendes Licht diffus in alle Richtungen. Dementsprechend sind in Fig. 7 die Markierungen 11 der Massskala 10 als Vertiefungen, welche in der Oberfläche 2.1 ausgebildet sind, erkennbar (die Referenz-Markierungen 12 sind nicht dargestellt, haben aber ansonsten dasselbe Höhenprofil wie die Markierungen 11). In Fig. 7 stellen (gestrichelte) Pfeile BR das jeweils reflektierte Licht dar, welches an den an die Markierungen 11 bzw. 12 angrenzenden Bereichen der Oberfläche 2.1 unter dem Reflexionswinkel θ gerichtet reflektiert wird. Die Pfeile BS in Fig. 1 stellen die Ausbreitungsrichtung von diffus gestreutem Licht dar, welches das einfallende Licht B im Bereich der Markierungen 11 (und entsprechend im Bereich der nicht dargestellten Referenz-Markierungen 12) erzeugt. Wie ersichtlich, breitet sich ein Teil des an den Markierungen 11 diffus gestreuten Lichts BS senkrecht zur Oberfläche 2.1 und somit in Richtung der optischen Achse 34 des Linsenelements 33 aus, sodass ein Teil des an der jeweiligen Markierung 11 diffus gestreuten Lichts BS das Linsenelement 33 durchdringen kann.

Es ist zweckmässig, den Einfallswinkel θ des mittels der Beleuchtungsvorrichtung 38 erzeugbaren Lichts B so zu wählen, dass das gerichtet reflektierte Licht BR nicht auf das Linsenelement 33 trifft. Diese Bedingung kann beispielsweise für einen Einfallswinkel θ von ungefähr 45° erfüllt werden. Unter der genannten Voraussetzung sind die an die Markierungen 11 bzw. 12 angrenzenden Bereichen der Oberfläche 2.1 in dem mittels des telezentrischen optischen Systems 30 erzeugten Bild der Massskala 10 dunkel und lediglich die Markierungen 11 bzw. 12 erscheinen als helle Bereiche. Auf diese Weise erzeugt das telezentrische optische System 30 ein besonders kontrastreiches Bild der Markierungen 11 und 12.

Fig. 8 zeigt (in Form eines Blockschaltbilds) eine schematische Darstellung des Sensors 40 des Messkopfes 21. Der Sensor 40 umfasst:
- eine photosensitive Fläche 41 zum ortsaufgelösten Erfassen eines mittels des telezentrischen optischen Systems 30 erzeugten Bildes; die photosensitive Fläche 41 umfasst im vorliegenden Beispiel eine Anordnung von Photodetektoren (Pixel), welche vier parallel zueinander angeordnete Sensor-Zeilen P1, P2, P3 und P4 und ein Sensorfeld P5 aufweist, wobei die Sensor-Zeilen P1-P4 zum Erfassen eines mittels des telezentrischen optischen Systems 30 erzeugten Bildes der Markierungen 11 der Inkrementalspur 11' und das Sensorfeld P5 zum Erfassen eines mittels des telezentrischen optischen Systems 30 erzeugten Bildes der Markierungen 12 der Referenz-Spur 12*'* dienen und die folgenden Eigenschaften haben: Jede der Sensor-Zeilen P1-P4 erfasst eine räumliche Verteilung einer Lichtintensität in Längsrichtung der jeweiligen Sensor-Zeile, wobei die jeweilige Sensor-Zeile P1, P2, P3 bzw. P4 jeweils ein (in der Regel analoges) Signal S1, S2, S3 bzw. S4 (in dieser Reihenfolge) bereitstellt, welches Signal S1, S2, S3 bzw. S4 die von der jeweiligen Sensor-Zeile P1, P2, P3 bzw. P4 erfasste Lichtintensitätsverteilung repräsentiert; das Sensorfeld P5 besteht aus einer zweidimensionalen Anordnung von Photodetektoren (Pixel), welche die räumliche Verteilung einer Lichtintensität auf dem Sensorfeld P5 erfassen, wobei das Sensorfeld P5 ein Signal S5 bereitstellt, welches die erfasste Lichtintensitätsverteilung repräsentiert;
- eine elektronische Schaltung 42 zur Aufbereitung der Signale S1-S4 und S5, welche Schaltung mit der photosensitiven Fläche 41 über vier Leitungen zum Empfang der Signale S1, S2, S3 bzw. S4 der Sensor-Zeilen P1, P2, P3 bzw. P4 und eine Leitung zum Empfang des Signals S5 des Sensorfeldes P5 verbunden ist, eine elektronische Aufbereitung der jeweiligen Signale S1-S5 (z.B. eine Verstärkung und/oder Linearisierung der jeweiligen Signale S1-S4 und/oder eine Kompensation unerwünschter elektrischer Gleichspannungspegel) durchführt und für jedes der Signale S1, S2, S3, S4 bzw. S5 ein entsprechend aufbereitetes Signal S1*'*, S2', S3', S4' bzw. S5' bereitstellt und
- eine elektronische Schaltung 43 zur Bestimmung einer Position des Sensors 40 bezüglich der Massskala 10 mittels einer Auswertung der Signale S1*'*, S2', S3' , S4' und S5', wobei die elektronische Schaltung 43 mit der elektronischen Schaltung 42 über vier Leitungen zum Empfang der Signale S1*'*, S2', S3*'* bzw. S4' und eine weitere Leitung zum Empfang des Signals S5' verbunden ist.

Wie Fig. 8 weiterhin andeutet, umfasst die elektronische Schaltung 43 eine Schnittstelle 44, welche über einen ersten digitalen Ausgabekanal 44.1 und einen zweiten digitalen Ausgabekanal 44.2 verfügt. Über den ersten digitalen Ausgabekanal 44.1 stellt die elektronische Schaltung 43 digitale Ausgangssignale A1 bereit, welche eine mittels einer Auswertung der Signale S1*'*, S2', S3' , S4' ermittelte Position des Sensors 40 bezüglich der Inkrementalspur 11' kodieren. Über den zweiten digitalen Ausgabekanal 44.2 stellt die elektronische Schaltung 43 digitale Ausgangssignale A2 bereit, welche eine mittels einer Auswertung des Signals S5*'* ermittelte Position des Sensors 40 bezüglich der Referenz-Spur 12' kodieren. Die Ausgangssignale A1 und A2 sind der Kontrolleinheit über die digitalen Ausgabekanäle 44.1 bzw. 44.2 zugänglich und können deshalb von der Kontrolleinheit verwendet werden.

Die Funktion des Sensors 40 und insbesondere die Funktion der elektronischen Schaltung 43 wird im Folgenden näher erläutert anhand der Fig. 9. Fig. 9 zeigt eine Projektion eines mittels des telezentrischen optischen Systems 30 erzeugten Bildes der Massskala 10 auf die photosensitive Fläche 41 des Sensors 40. In diesem Zusammenhang ist angenommen, dass die Massskala 10 mittels der Beleuchtungsvorrichtung 38 derart beleuchtet ist, dass ausschliesslich das an den Markierungen 11 bzw. 12 diffus reflektierte Licht das Linsenelement 33 erreicht, sodass ausschliesslich die Markierungen 11 bzw. 12 im erzeugten Bild sichtbar sind (wie im Zusammenhang mit Fig. 7 erläutert). In Fig. 9 stellt jede mit B11 bezeichnete Fläche das jeweils erzeugte Bild einer Markierung 11 der Inkrementalspur 11' und jede mit B12 bezeichnete Fläche das jeweils erzeugte Bild einer Referenz-Markierung 12 der Referenzspur 12*'* dar.

Im vorliegenden Fall ist angenommen, dass das telezentrische optische System 30 ein vergrössertes Bild der Massskala 10 auf die photosensitive Fläche 41 des Sensors 40 projiziert. Das jeweilige Bild der Massskala 10 könnte beispielsweise um einen Faktor 2.5 (oder einen anderen Faktor) im Vergleich zur Massskala 10 vergrössert sein. Im Falle eines vergrösserten Bildes können zum Erfassen des Bildes jeweils Sensor-Zeilen P1-P4 bzw. ein Sensorfeld P5 verwendet werden, welche eine grössere Fläche aufweisen als entsprechende Sensoren, die zum Erfassen eines nicht vergrösserten Bildes ausgelegt sind. Letzteres resultiert beispielsweise in einem verbesserten Signal-Rausch-Verhältnis der Signale S1-S4 und S5 und bietet eine Voraussetzung dafür, dass die Signale S1*'*-S4*'* bzw. S5*'* mittels der elektronischen Schaltung 43 entweder genauer (in einer vorgegebenen Zeit) oder schneller (bei einer vorgegebenen Genauigkeit) ausgewertet werden können.

Wie Fig. 9 andeutet, definieren die Flächen B11 eine periodische Teilung einer in der Längsrichtung der Spur 11*'* angeordneten geraden (in Fig. 9 horizontal ausgerichteten) Linie mit der Periode LS (in Fig. 9 durch einen Doppelpfeil gekennzeichnet), wobei die Flächen B11 im Wesentlichen rechteckig ausgebildet sind und eine Längsachse aufweisen, welche senkrecht zur Längsrichtung der Spur 11*'* ausgerichtet ist. Wie Fig. 9 weiter andeutet, haben die jeweiligen Sensor-Zeilen P1, P2, P3 bzw. P4 ebenfalls eine im Wesentlichen rechteckige Form und weisen jeweils eine Längsachse auf, welche senkrecht zur Längsrichtung der Spur 11*'* ausgerichtet ist. Weiterhin weisen die Sensor-Zeilen P1, P2, P3 bzw. P4 jeweils die gleiche Fläche auf und sind bezüglich der Längsrichtung der Spur 11*'* jeweils nebeneinander angeordnet, wobei benachbarte Sensor-Zeilen P1, P2, P3 bzw. P4 jeweils in gleichem Abstand zueinander angeordnet sind.

Wie Fig. 9 andeutet, ist die Grösse der jeweiligen Sensor-Zeilen P1, P2, P3 bzw. P4 so gewählt, dass die Erstreckung aller Sensor-Zeilen P1, P2, P3 bzw. P4 in der Längsrichtung der Spur 11' gesamthaft der Periode LS der Anordnung der Flächen B11 entspricht. Demnach teilen die Sensor-Zeilen P1, P2, P3 und P4 eine Periode der Anordnung der Flächen B11 in vier gleiche Teile. Wie aus Fig. 9 ersichtlich, ist die Grösse der jeweiligen Sensor-Zeilen P1, P2, P3 bzw. P4 weiterhin so gewählt, dass sie ebenfalls die jeweiligen Bilder der Referenz-Markierungen 12 der Referenz-Spur 12', d.h. die Flächen B12, erfassen können.

Zum Erfassen eines mittels des telezentrischen optischen Systems 30 erzeugten Bildes der Massskala 10 wird der Messkopf 21 in der Längsrichtung der Massskala 10 bewegt, mit dem Effekt, dass die Sensor-Zeilen P1, P2, P3 bzw. P4 der photosensitiven Fläche 41 des Sensors 40 relativ zu den Flächen B11 des Bildes der Inkrementalspur 11' bzw. und das Sensorfeld P5 der photosensitiven Fläche 41 des Sensors 40 relativ zu den Flächen B12 des Bildes der Referenz-Spur 12' in der Längsrichtung der jeweiligen Spur bewegt werden, beispielsweise in Richtung des Pfeils 60 gemäss Fig. 9.

Werden die Sensor-Zeilen P1, P2, P3 bzw. P4 in Richtung des Pfeils 60 relativ zu den Flächen B11 der Inkremental-Spur 11*'* bewegt, so erzeugen die Sensor-Zeilen P1, P2, P3 bzw. P4 Signale S1, S2, S3 und S4, welche jeweils sinusförmig als Funktion des Orts des Messkopfes 21 variieren, wobei sich der Verlauf jedes der Signale S1, S2, S3 bzw. S4 periodisch als Funktion des Orts nach jedem Durchlaufen einer Strecke der Länge LS identisch wiederholt. Weiterhin sind die Signale S1, S2, S3 bzw. S4 jeweils identisch, abgesehen von einem Phasenunterschied zwischen verschiedenen Signalen S1, S2, S3 bzw. S4: Das Signal S3 hat gegenüber dem Signal S4 einen Phasenunterschied von 90°, das Signal S2 hat gegenüber dem Signal S4 einen Phasenunterschied von 180° und das Signal S1 hat gegenüber dem Signal S4 einen Phasenunterschied von 270°. Da die jeweiligen Phasenunterschiede zwischen den Signalen S1, S2, S3 bzw. S4 somit bekannt sind, kann die elektronische Schaltung 43 jeweils verschiedene Signale S1*'*-S4*'* erfassen und miteinander vergleichen und beispielsweise aus zwei verschiedenen, um 90° zueinander phasenverschobenen Signalen mittels einer Interpolation den jeweiligen Ort des Messkopfes mit einer Ungenauigkeit bestimmen, welche geringer ist als der Abstand benachbarter Markierungen 11 der Inkremental-Spur 11*'*.

Die elektronische Schaltung 43 kann die jeweils bestimmten Positionen, welche der Sensor nacheinander beim Abtasten der Inkremental-Spur 11*'* durchläuft, in Form von Signalen A1 kodieren, welche beispielsweise Folgen von Rechtecksignalen bilden, wobei die Flanken der jeweiligen Rechtecksignale jeweils vorgegebene Positionen bezüglich der jeweiligen Markierungen 11 kennzeichnen.

Wird das Sensorfeld P5 in Richtung des Pfeils 60 relativ zu den Flächen B12 der Referenz-Spur 12' bewegt, so erzeugen die Photodetektoren des Sensorfelds P5 bei einer Bewegung über eine Fläche B12 Signale S5, welche sich in Abhängigkeit von der Position des Sensorfelds P5 relativ zur jeweiligen Fläche B12 verändern. Die elektronische Schaltung 43 ist dazu ausgelegt, auch die einer Fläche B12 zuzuordnenden Signale S5 auszuwerten und daraus eine Verschiebung des Sensors 40 bzw. des Sensorfelds P5 relativ zu einer der Referenz-Markierungen 12 zu bestimmen. Die elektronische Schaltung 43 bestimmt mittels einer Auswertung der Signale S5' die Position, welche das Sensorfeld P5 bezüglich der Referenz-Spur 12' einnimmt, und kodiert die jeweils bestimmte Position in Form von digitalen Signalen A2, welche mittels der Schnittstelle 44 über den zweiten digitalen Ausgabekanal 44.2 ausgegeben werden können.

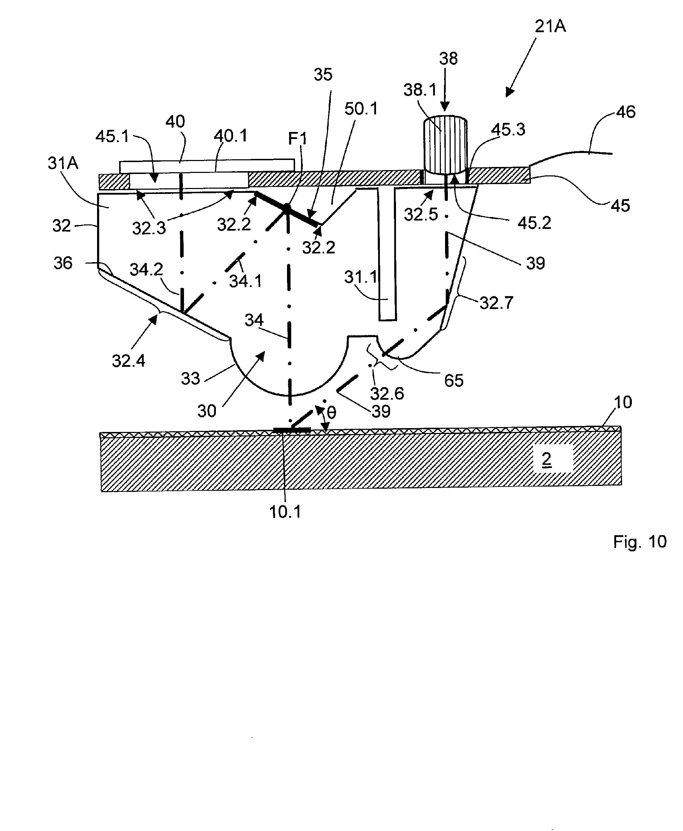

Fig. 10 zeigt eine zweite Ausführungsform der erfindungsgemässen Vorrichtung 5 zur Bestimmung einer Position. Diese Ausführungsform ist hinsichtlich einzelner Merkmale identisch mit der Ausführungsform gemäss Fig. 5, wobei in Fig. 5 und 10 jeweils identische Gegenstände mit identischen Bezugszeichen gekennzeichnet sind. Die Ausführungsform gemäss Fig. 10 umfasst dieselbe (an einer Oberfläche der Führungsschiene 2 ausgebildete) Massskala 10 wie die Ausführungsform gemäss Fig. 5 und einen Messkopf 21A zum optischen Abtasten der Massskala 10. Der Messkopf 21A gemäss Fig. 10 unterscheidet sich von dem Messkopf 21 gemäss Fig. 5 im Wesentlichen dadurch, dass der Block 31 gemäss Fig. 5 durch einen Block 31A ersetzt ist, der einerseits dieselbe Funktion erfüllt wie der Block 31, aber zusätzlich noch die Möglichkeit bietet, dass das Licht einer Beleuchtungsvorrichtung 38, welches zur Beleuchtung eines Bereichs 10.1 der Massskala dient, durch den Block 31A geführt werden kann. Dadurch werden, abweichend von der Ausführungsform gemäss Fig. 5, alternative Möglichkeiten geschaffen, die Beleuchtungsvorrichtung 38 anzuordnen und die Ausbreitung des von der Beleuchtungsvorrichtung erzeugten Lichts auf einem Weg zum Bereich 10.1 der Massskala 10 zu beeinflussen.

Wie Fig. 10 andeutet, umfasst der Block 31A einen Bereich (in Fig. 10 auf der linken Seite des Blocks 31A), welcher strukturell mit dem Block 30 übereinstimmt und im Wesentlichen alle Strukturelemente des Blocks 30 aufweist, welche das telezentrische optische System 30 gemäss Fig. 5 bilden: das in einem ersten Bereich der Oberfläche 32 des Blocks 31A angeordnete Linsenelement 33 mit der optischen Achse 34 und dem Fokus F1, die in einem zweiten Bereich 32.2 angeordnete, als telezentrische Apertur dienende und relativ zur optischen Achse 34 geneigte erste Spiegelfläche 35, die in einem vierten Bereich 32.4 angeordnete zweite Spiegelfläche 36 und den neben der ersten Spiegelfläche 35 angeordneten dritten Bereich 32.3 der Oberfläche 32, an welchem der Sensor 40 zum Erfassen eines mittels des telezentrischen optischen Systems 30 erzeugten Bildes der Massskala 10 angeordnet werden kann.

Der Sensor 40 ist im vorliegenden Beispiel an einer elektronischen Leiterplatte 45 befestigt, welche auf einer von der Massskala 10 abgewandten Seite des Blocks 31A angeordnet ist und strukturell und funktionell der Leiterplatte 45 gemäss Fig. 5 entspricht.

Wie Fig. 10 andeutet, umfasst der Block 31A unmittelbar neben dem Bereich (in Fig. 10 auf der rechten Seite des Blocks 31A), welcher das telezentrische System 30 bildet, einen weiteren Bereich, welcher dazu dient, das mittels der Beleuchtungsvorrichtung 38 erzeugte Licht zum Bereich 10.1 der Massskala 10 zu führen, und welcher dementsprechend zumindest umfasst: einen Bereich 32.5 der Oberfläche 32 des Blocks 31A, an welchem das mittels der Beleuchtungsvorrichtung 38 erzeugte Licht in den Block 31A einkoppelbar ist, und einen Bereich 32.6 der Oberfläche 32 des Blocks 31A, an welchem das Licht aus dem Block 31A auskoppelbar ist.

Im vorliegenden Fall ist der Bereich 32.5 der Oberfläche 32 - wie der Bereich 32.3 - auf einer von der Massskala 10 abgewandten Seite des Blocks 31A angeordnet. Dies hat den Vorteil, dass die Beleuchtungsvorrichtung 38 - wie in Fig. 10 angedeutet ist - an der Leiterplatte 45 befestigt sein kann, sodass die Leiterplatte 45, der Sensor 40 und die Beleuchtungsvorrichtung eine einzige elektronische Baugruppe bilden, welche als Ganzes in den Messkopf 21A montiert und als Ganzes ausgetauscht werden kann. Letzteres führt zu einer vereinfachten Montage des Messkopfes 21A, zumal alle elektrischen Anschlüsse der Beleuchtungsvorrichtung 38 und beispielweise eine Stromversorgung und eine Einrichtung zur Steuerung der Beleuchtungsvorrichtung 38 ebenfalls auf der Leiterplatte 45 angeordnet sein können und eine separate Montage der Beleuchtungsvorrichtung (unabhängig von einer Montage der Leiterplatte 45 und des Sensors 40) vermieden werden kann.

Im vorliegenden Beispiel umfasst die Beleuchtungsvorrichtung 38 eine oder mehrere Lichtquellen 38.1 (beispielsweise Leuchtdioden), welche derart angeordnet sind, dass das mittels der jeweiligen Lichtquelle 38.1 erzeugbare Licht senkrecht zur Leiterplatte in Richtung auf die Massskala 10 emittiert wird. Wie Fig. 10 andeutet, weist die Leiterplatte 45 in dem Bereich 32.5 der Oberfläche 32 des Blocks 31A gegenüber liegenden Abschnitt ein durchgehendes Loch 45.2 auf, welches derart platziert ist, dass das mittels der jeweiligen Lichtquelle 38.1 erzeugbare Licht durch dieses Loch 45.2 emittiert und in den Block 31 im Bereich 32.5 eingekoppelt werden kann. In Fig. 10 repräsentiert die gestrichelte Linie 39 den Verlauf eines aus der Lichtquelle 38.1 austretenden Lichtstrahls.

Falls das Material, aus dem die Leiterplatte 45 gefertigt ist, für das mittels der Beleuchtungsvorrichtung 38 erzeugte Licht transparent sein sollte, kann es zweckmässig sein, zumindest einen Bereich der Leiterplatte 45 am Loch 45.2 mit einer Schicht 45.3 aus einem absorbierenden oder reflektierenden Material abzudecken, um zu verhindern, dass das erzeugte Licht in die Leiterplatte 45 eingekoppelt und gegebenenfalls über die Leiterplatte zum Sensor 40 geleitet werden kann. Diese Massnahme kann verhindern, dass unerwünschtes Streulicht durch die Leiterplatte 45 zum Sensor 40 gelangen und eine Funktion des Sensors 40 beeinträchtigen kann.

Wie der Verlauf des Lichtstrahls 39 in Fig. 10 andeutet, wird das mittels der jeweiligen Lichtquelle 38.1 erzeugte Licht im vorliegenden Beispiel im Wesentlichen parallel zur optischen Achse 34 des Linsenelements 33 in den Block 31A eingekoppelt und trifft auf einen Bereich 32.7 der Oberfläche 32 des Blocks 31A, welcher als reflektierende Fläche ausgebildet ist und relativ zur optischen Achse 34 derart geneigt ist, dass das in den Block 31A eingekoppelte Licht im Bereich 32.7 derart reflektiert wird, dass es den Block 31A im Bereich 32.6 verlässt und den Bereich 10.1 der Massskala 10 unter einem Einfallswinkel θ < 90° erreicht. Der Bereich 32.7 der Oberfläche 32 kann so angeordnet sein, dass die Reflexion des Lichtstrahls 39 im Bereich 32.7 der Oberfläche 32 mittels Totalreflexion erfolgt. Der Einfallswinkel θ wird im vorliegenden Beispiel bevorzugt so gewählt, dass das Licht, welches am Bereich 10.1 gerichtet reflektiert wird, nicht auf das Linsenelement 33 trifft (wie im Fall der Ausführungsform gemäss Fig. 5).

Wie Fig. 10 weiterhin andeutet, weist der Bereich 32.6 der Oberfläche 32 des Blocks 31A eine Krümmung auf, sodass der Bereich 32.6 ein Linsenelement 65 bildet. Im vorliegenden Beispiel ist der Bereich 32.6 konvex gekrümmt. Der Bereich 32.6 kann beispielsweise derart ausgebildet sein, dass das Linsenelement 65 das jeweils aus dem Block 31A ausgekoppelte Licht kollimiert oder auf den Bereich 10.1 fokussiert.

Die Beleuchtungsvorrichtung 38 kann beispielsweise eine einzige Lichtquelle 38.1 umfassen, welche derart ausgelegt ist, dass sie sowohl die Inkrementalspur 11' als auch die Referenzspur 12*'* der Massskala 12 im Bereich 10.1 beleuchten kann. Alternativ kann die Beleuchtungsvorrichtung 38 auch mehrere Lichtquellen 38.1 umfassen, welche jeweils derart angeordnet sind, dass verschiedene Lichtquellen 38.1 verschiedene Bereiche der Massskala 10 beleuchten können. Beispielsweise können die Inkrementalspur 11' und die Referenz-spur 12*'* jeweils mit verschiedenen Lichtquellen 38.1 beleuchtet werden. Entsprechend können im Bereich 32.6 der Oberfläche 32 des Blocks 31A mehrere verschiedene Linsenelemente 65 ausgebildet sein, sodass Licht verschiedener Lichtquellen 38.1 jeweils über verschiedene Linsenelemente 65 aus dem Block 31A ausgekoppelt werden kann.

Gemäss Fig. 10 umfasst der Block 31A (optional) eine Nut 31.1, welche sich einerseits in Richtung der optischen Achse 34 und andererseits senkrecht zur Zeichenebene in Fig. 10 erstreckt und zwischen dem telezentrischen optischen System 30 und dem Bereich 32.5 der Oberfläche 32 des Blocks 31A angeordnet ist. Die Nut 31.1 isoliert das telezentrische optische System 30 gegen das Licht der jeweiligen Lichtquelle 38.1, welches in den Block 31A eingekoppelt wird, und verhindert somit, dass unerwünschtes Streulicht durch den Block 31A zum Sensor 40 gelangen könnte. In der Nut 31.1 können zusätzlich Werkstoffe platziert werden, welche Licht reflektieren oder absorbieren. Letzteres kann die genannte Isolation des telezentrischen optischen Systems 30 gegen unerwünschtes Streulicht noch verbessern.

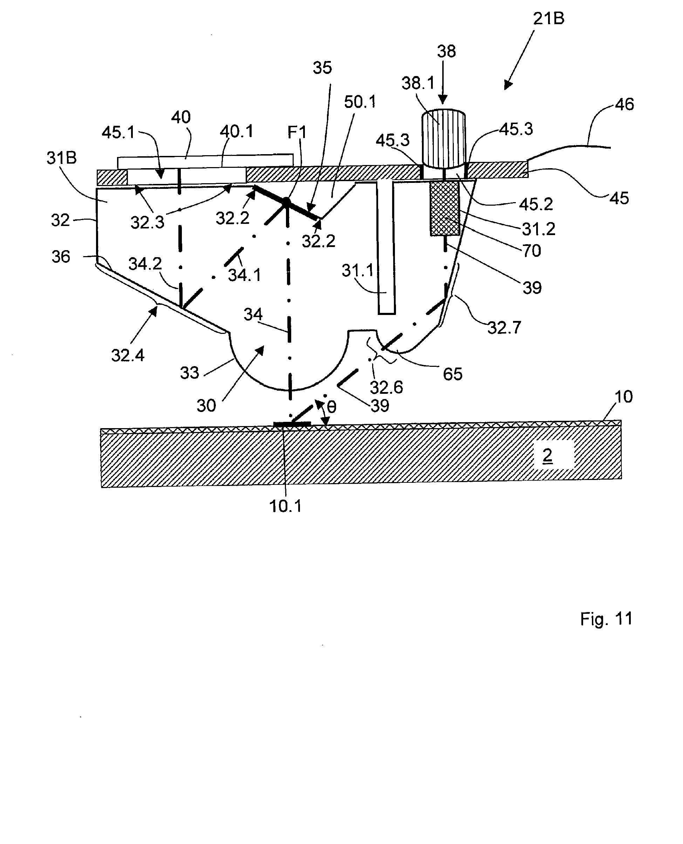

Fig. 11 zeigt eine dritte Ausführungsform der erfindungsgemässen Vorrichtung 5 zur Bestimmung einer Position. Diese Ausführungsform ist hinsichtlich einer Vielzahl von Merkmalen identisch mit der Ausführungsform gemäss Fig. 10, wobei in Fig. 10 und 11 jeweils identische Gegenstände mit identischen Bezugszeichen gekennzeichnet sind.

Die Ausführungsform gemäss Fig. 11 umfasst dieselbe (an einer Oberfläche der Führungsschiene 2 ausgebildete) Massskala 10 wie die Ausführungsform gemäss Fig. 10 und einen Messkopf 21B zum optischen Abtasten der Massskala 10. Der Messkopf 21B gemäss Fig. 11 unterscheidet sich von dem Messkopf 21A gemäss Fig. 10 im Wesentlichen dadurch, dass der Block 31A gemäss Fig. 10 durch einen Block 31B ersetzt ist, wobei der Block 31B einerseits im Wesentlichen dieselbe Funktion erfüllt wie der Block 31A, d.h. auch der Messkopf 21B bietet die Möglichkeit, dass das Licht einer Beleuchtungsvorrichtung 38, welches zur Beleuchtung eines Bereichs 10.1 der Massskala dient, durch den Block 31B geführt werden kann und zu diesem Zweck in einem Bereich des Blocks 31B in den Block 31B eingekoppelt und an einem anderen Bereich des Blocks 31B aus dem Block 31B ausgekoppelt werden kann.

Der Messkopf 21B gemäss Fig. 11 unterscheidet sich von dem Messkopf 21A im Wesentlichen durch die Art und Weise, wie das Licht der Beleuchtungsvorrichtung 38 in den Block 31B eingekoppelt wird. Diejenigen Komponenten des Messkopfs 21B, welche nicht die Einkopplung des mittels der Beleuchtungsvorrichtung 38 erzeugten Lichts in den Block 31B betreffen, sind identisch mit den entsprechenden Komponenten des Messkopfs 21A. Insbesondere umfassen die Messköpfe 21A und 21B dasselbe telezentrische optische System 30, denselben Sensor 40, dieselbe Leiterplatte 45 und dieselbe Beleuchtungsvorrichtung 38.

Wie Fig. 11 andeutet, umfasst der Messkopf 21B einen Lichtleiter 70, welcher derart angeordnet ist, dass mittels einer Lichtquelle 38.1 erzeugtes Licht über den Lichtleiter 70 in den Block 31B einkoppelbar ist. Der Lichtleiter 70 ist im vorliegenden Beispiel geradlinig ausgebildet und umfasst ein Ende, welches an dem Loch 45.3 derart angeordnet ist, dass das von der jeweiligen Lichtquelle 38.1 erzeugte Licht in dieses Ende des Lichtleiters 70 eingekoppelt und zum anderen Ende des Lichtleiters 70 geführt wird. An diesem anderen Ende des Lichtleiters 70 kann das Licht aus dem Lichtleiter 70 austreten und sich innerhalb des Blocks 31B ausbreiten, bis es im Bereich 32.6 der Oberfläche 32 des Blocks 31B in Richtung des Bereichs 10.1 der Massskala 10 ausgekoppelt wird.

In Fig. 11 repräsentiert die gestrichelte Linie 39 den Verlauf eines aus der Lichtquelle 38.1 austretenden Lichtstrahls durch den Block 31B bis zum Bereich 10.1 der Massskala 10. Wie aus Fig. 11 ersichtlich, trifft das aus dem Lichtleiter 10 austretende Licht auf einen Bereich 32.7 der Oberfläche 32 des Blocks 31B, welcher als reflektierende Fläche ausgebildet ist und relativ zur optischen Achse 34 derart geneigt ist, dass das aus dem Lichtleiter 70 austretende Licht im Bereich 32.7 derart reflektiert wird, dass es den Block 31B im Bereich 32.6 verlässt und den Bereich 10.1 der Massskala 10 unter einem Einfallswinkel θ < 90° erreicht.

Wie Fig. 11 weiterhin andeutet, weist der Bereich 32.6 der Oberfläche 32 des Blocks 31B eine Krümmung auf, sodass der Bereich 32.6 ein Linsenelement 65 bildet. Im vorliegenden Beispiel ist der Bereich 32.6 konvex gekrümmt. Der Bereich 32.6 kann beispielsweise derart ausgebildet sein, dass das Linsenelement 65 das jeweils aus dem Block 31 ausgekoppelte Licht kollimiert oder auf den Bereich 10.1 fokussiert.

Der Lichtleiter 70 kann auf unterschiedliche Weisen realisiert werden. Der Lichtleiter 70 kann beispielsweise ein separates Bauteil sein, welches in einer im Block 31B ausgebildeten Ausnehmung 31.2 platziert werden kann. Alternativ kann der Lichtleiter 70 auch in den Block 31B integriert sein, sodass der Block 31B zusammen mit dem Lichtleiter 70 ein einstückiges Bauteil bildet.

Abweichend von der Darstellung gemäss Fig. 11, muss der Lichtleiter 70 nicht geradlinig ausgebildet sein: der Lichtleiter 70 kann das Licht der jeweiligen Lichtquelle 38.1 auch entlang einer gekrümmten Kurve führen, wobei ein Ende des Lichtleiters beispielsweise an der jeweiligen Lichtquelle 38.1 angeordnet ist und das andere Ende des Lichtleiters an dem jeweiligen Linsenelement 65 angeordnet ist. In diesem Fall kann das Licht der Lichtquelle 38.1 bis zum Linsenelement 65 mithilfe des Lichtleiters geführt werden.

Die Blöcke 31, 31A und 31B können kostengünstig jeweils als einstückiges Bauteil aus Kunststoff hergestellt werden, beispielsweise mittels Spritzgiessen oder Spritzprägen. Für eine Herstellung mittels Spritzgiessen oder Spritzprägen können im wesentlichen konventionelle Formwerkzeuge verwendet werden. Um zu erreichen, dass diejenigen Bereiche der Oberfläche des jeweiligen Blocks, welche die Qualität eines mit dem telezentrischen optischen System 30 erzeugten Bildes beeinflussen können (d.h. beispielsweise die Bereiche 32.1, 32.2, 32.4, 32.6), mit einer besonders hohen Genauigkeit und mit einer besonders geringen Rauhigkeit geformt werden können, können die jeweiligen Formwerkzeuge mit einzelnen Einsätzen versehen sein, deren Oberflächen mit einer besonders hohen Präzision bearbeitet sind und die speziell zum Formen der genannten Oberflächenbereiche des jeweiligen Blocks bestimmt sind. Derartige Einsätze können beispielsweise durch eine Bearbeitung eines aus einem Metall gefertigten Werkstücks mittels Diamantwerkzeugen (beispielsweise mittels Diamantdrehen) hergestellt werden.

Diejenigen Bereiche der Oberflächen der Blöcke 31, 31A und 31B, welche jeweils als Spiegelfläche bzw. reflektierende Fläche ausgebildet sind bzw. verwendet werden (d.h. beispielsweise die Bereiche 32.2, 32.4, 32.7), können mit einer Beschichtung versehen sein, welche die Reflektivität der jeweiligen Bereiche der Oberfläche der Blöcke 31, 31A und 31B erhöht.

Die erfindungsgemässe Vorrichtung 5 kann unter Berücksichtung der folgenden Kriterien optimiert werden:
a) Das telezentrische optische System 30 erzeugt (wie bereits erwähnt) ein Bild der Massskala 10 mit einer Tiefenschärfe, welche von der Grösse der telezentrischen Apertur, d.h. der Grösse der ersten Spiegelfläche 35, abhängt und umso grösser ist, je kleiner die Fläche der Apertur ist. Die Toleranz, mit welcher ein vorgegebener Abstand des jeweiligen Messkopfs 21, 21A bzw. 21B bezüglich der Massskala 10 beim Abtasten der Massskala eingehalten werden muss, ist demnach umso grösser, je kleiner die Fläche der ersten Spiegelfläche 35 ist. Andererseits sind die Signale S1-S4 des Sensors 40 und entsprechend das jeweilige Signal-Rausch-Verhältnis der Signale S1-S4 (bei einer vorgegebenen Intensität des mittels der Beleuchtungsvorrichtung 38 erzeugten Lichts) umso grösser, je grösser die Fläche der ersten Spiegelfläche 35 ist. Das jeweilige Signal-Rausch-Verhältnis der Signale S1-S4 bestimmt wiederum, die Genauigkeit, mit welcher in einem vorgegebenen Zeitintervall die jeweils zu bestimmende Position ermittelt werden kann. Eine optimale Grösse der Spiegelfläche 35 kann deshalb als ein Kompromiss zwischen der Anforderung, die Tiefenschärfe des telezentrischen optischen Systems 30 zu maximieren, und der Anforderung, das Signal-Rausch-Verhältnis der Signale S1-S4 des Sensors 40 zu maximieren, ermittelt werden.
b) Bei einer Massskala 10 der genannten Art (d.h. einer Massskala, deren Markierungen durch eine Bearbeitung einer Oberfläche einer Führungsschiene mittels Laserstrahlen erzeugt wurden) ist es möglich, dass die Massskala 10 über ihre gesamte Länge eine Inhomogenität hinsichtlich der Beschaffenheit der jeweiligen Markierungen (insbesondere hinsichtlich der Reflektivität der jeweiligen Markierungen) zeigt. Dies hat zur Folge, dass die Signale S1, S2, S3, S4 und S5 Schwankungen aufweisen können, welche mit der jeweiligen Position des jeweiligen Messkopfs bezüglich der Massskala 10 korrelieren. Diese Schwankungen können kompensiert werden, beispielsweise mittels einer Regelung der Intensität des mittels der Beleuchtungsvorrichtung 38 erzeugten Lichts oder einer Regelung der jeweiligen Verstärkung von (beispielsweise in der elektronischen Schaltung 42 enthaltenen) elektronischen Verstärkern zur Verstärkung der jeweiligen Signale S1, S2, S3, S4 und S5.
c) Verschmutzungen (z.B. Ölfilme, Abriebpartikel oder andere Partikel), welche auf der Massskala 10 beliebig verteilt sein können, streuen das von der Beleuchtungsvorrichtung 38 erzeugte Licht gegebenenfalls auf das Linsenelement 33. Dadurch kann das Signal-Rausch-Verhältnis der jeweiligen Signale S1, S2, S3, S4 und S5 reduziert werden. Der störende Einfluss der Verschmutzungen hängt u.a. von der Grösse der jeweiligen Schmutzpartikel ab. Grundsätzlich ist die Intensität des von Verschmutzungen hervorgerufenen Streulichts umso kleiner, je grösser die Wellenlänge des von der Beleuchtungsvorrichtung 38 erzeugten Lichts ist. Andererseits hängt die Grösse der Signale S1-S4 von der jeweiligen spektralen Empfindlichkeit der photosensitiven Fläche 41 des Sensors 40 ab. Eine optimale Grösse der Wellenlänge λ des von der Beleuchtungsvorrichtung 38 erzeugten Lichts kann deshalb als ein Kompromiss zwischen der Anforderung, die Intensität des von Verschmutzungen hervorgerufenen Streulichts auf ein Minimum zu reduzieren, und der Anforderung, die spektralen Empfindlichkeit der photosensitiven Fläche 41 des Sensors 40 zu maximieren, ermittelt werden. Unter der Voraussetzung, dass die photosensitive Fläche 41 des Sensors 40 auf der Grundlage konventioneller Silizium-Technologie gefertigt ist, ergibt sich in diesem Fall ein optimaler Wellenlängenbereich von 700 nm < λ < 900 nm.

Unter Berücksichtigung der vorstehend genannten Optimierungskriterien erlaubt es die erfindungsgemässe Vorrichtung 5, eine Position des jeweiligen Messkopfs 21 bzw. 21A bzw. 21B bezüglich der Massskala 10 mit einer Genauigkeit von 100 nm bei einer Geschwindigkeit des Messkopfs 21 bzw. 21A bzw. 21B in Längsrichtung der Massskala von 5 m/s zu bestimmen. Dabei ist vorausgesetzt, dass die Markierungen 11 jeweils eine Erstreckung in der Längsrichtung der Massskala 10 von 5-10 µm haben und beispielsweise in Abständen von 10-20 µm relativ zueinander angeordnet sind. Weiterhin ist angenommen, dass die Grösse der ersten Spiegelfläche 35 so gewählt ist, dass ein vorgegebener Abstand des jeweiligen optischen Systems 30 bezüglich der Massskala 10 beim optischen Abtasten der Massskala 10 mit einer Toleranz von ca. ±110 µm eingehalten werden muss.

## Patentansprüche

1. Vorrichtung (5) zur Bestimmung einer Position, umfassend:
eine Massskala (10) mit einer oder mehreren Markierungen (11, 12) zur Kennzeichnung einer Position und einen relativ zur Massskala (10) bewegbaren Messkopf (21, 21A,
21B) zum optischen Abtasten der Massskala (10),
welcher Messkopf (21, 21A, 21B) ein telezentrisches optisches System (30) zur Erzeugung eines Bildes der Massskala (10) und einen Sensor (40) zum Erfassen des Bildes der Massskala (10) und zum Bereitstellen von Signalen (S1, S2, S3, S4, S5) umfasst, welche Signale eine Bestimmung der Position des Messkopfes (21, 21A, 21B) relativ zur Massskala (10) ermöglichen,
wobei das telezentrische optische System (30) ein in einem Abstand zur Massskala (10) angeordnetes und eine optische Achse (34) aufweisendes erstes Linsenelement (33) und eine Apertur (35), welche an einem Fokus (F1) des ersten Linsenelements (33) auf einer von der Massskala (10) abgewandten Seite des Linsenelements (33) angeordnet ist, umfasst,
**dadurch gekennzeichnet, dass**
das telezentrische optische System (30) einen eine Oberfläche (32) aufweisenden Block (31, 31A, 31B) umfasst,
wobei das erste Linsenelement (33) integraler Bestandteil des Blocks (31, 31A, 31B) ist und ein erster Bereich (32.1) der Oberfläche (32) des Blocks (31, 31A,
31B) eine Oberfläche des ersten Linsenelements (33) bildet und
wobei die Apertur in Form einer ersten Spiegelfläche (35) realisiert ist, welche an einem zweiten Bereich (32.2) der Oberfläche (32) des Blocks (31, 31A, 31B) ausgebildet ist und bezüglich der optischen Achse (34) des ersten Linsenelements (33) geneigt (ϕ<90°) ist.

2. Vorrichtung (5) nach Anspruch 1, wobei der Sensor (40) an einem dritten Bereich (32.3) der Oberfläche (32) des Blocks (31, 31A, 31B) angeordnet ist.

3. Vorrichtung (5) nach Anspruch 2, wobei die erste Spiegelfläche (35) derart angeordnet ist, dass Licht entlang der optischen Achse (34) derart durch das erste Linsenelement (33) in den Block (31, 31A, 31B) einkoppelbar ist, dass das jeweils eingekoppelte Licht an der ersten Spiegelfläche (35) reflektiert wird und den Block (31, 31A, 31B) am dritten Bereich (32.3) der Oberfläche (32) des Blocks (31, 31A, 31B) verlässt.

4. Vorrichtung (5) nach Anspruch 2, wobei an einem vierten Bereich (32.4) der Oberfläche (32) des Blocks (31, 31A, 31B) eine oder mehrere zweite Spiegelflächen (36) ausgebildet sind und die jeweiligen zweiten Spiegelflächen (36) relativ zur ersten Spiegelfläche (35) derart angeordnet sind, dass Licht entlang der optischen Achse (34) derart durch das erste Linsenelement (33) in den Block (31, 31A, 31B) einkoppelbar ist, dass das jeweils eingekoppelte Licht an der ersten Spiegelfläche (35) und anschliessend an mindestens einer der zweiten Spiegelflächen (36) reflektiert wird und schliesslich den Block (31, 31A, 31B) am dritten Bereich (32.3) der Oberfläche verlässt.

5. Vorrichtung (5) nach einem der Ansprüche 1-4,
mit einer Beleuchtungsvorrichtung (38) mit mindestens einer Lichtquelle (38.1), mittels welcher mindestens ein Bereich (10.1) der Massskala (10) beleuchtbar ist, wobei der jeweilige Bereich (10.1) der Massskala (10) derart angeordnet ist, dass mittels des telezentrischen optischen Systems (30) ein Bild des jeweiligen Bereichs (10.1) der Massskala (10) erzeugbar und dieses Bild mit dem Sensor (40) erfassbar ist.

6. Vorrichtung (5) nach Anspruch 5, wobei die jeweilige Lichtquelle (38.1) derart angeordnet ist, dass mittels der Lichtquelle (38.1) erzeugtes Licht an einem Bereich (32.5) der Oberfläche (32) des Blocks (31A, 31B) in den Block einkoppelbar und an einem anderen Bereich (32.6) der Oberfläche (32) des Blocks (31A) auskoppelbar ist.

7. Vorrichtung (5) nach Anspruch 6, wobei
derjenige Bereich (32.6) der Oberfläche des Blocks (31A, 31B), an welchem mittels der jeweiligen Lichtquelle (38.1) erzeugtes Licht auskoppelbar ist, eine Krümmung aufweist, sodass dieser Bereich der Oberfläche ein Linsenelement (65) bildet.

8. Vorrichtung (5) nach einem der Ansprüche 6 oder 7, wobei an einem Bereich (32.7) der Oberfläche (32) des Blocks (31A, 31B) eine reflektierende Fläche ausgebildet ist, welche derart angeordnet ist, dass das jeweils in den Block (31A, 31B) eingekoppelte Licht der jeweiligen Lichtquelle (38.1) an dieser reflektierenden Fläche reflektiert wird.

9. Vorrichtung (5) nach einem der Ansprüche 6-8,
mit einem oder mehreren Lichtleitern (70), wobei die jeweiligen Lichtleiter (70) derart angeordnet sind, dass mittels der jeweiligen Lichtquelle (38.1) erzeugtes Licht über einen der jeweiligen Lichtleiter (70) in den Block (31B) einkoppelbar ist.

10. Vorrichtung nach Anspruch 9, wobei
der Block (31B) mindestes eine Ausnehmung (31.2) aufweist, in welcher der jeweilige Lichtleiter (70) angeordnet ist, oder der Lichtleiter (70) in den Block (31B) integriert ist.

11. Vorrichtung (5) nach einem der Ansprüche 5-10, wobei die Massskala (10) aufweist: eine oder mehrere Inkrementalspuren (11') mit jeweils mehreren inkrementell angeordneten Markierungen (11) und/oder eine oder mehrere Referenzspuren (12') mit einer oder mehreren Referenz-Markierungen (12).

12. Vorrichtung (5) nach einem der Ansprüche 5-11, wobei die Massskala (10) eine Mehrzahl von Markierungen (11, 12) aufweist, welche in mehreren nebeneinander angeordneten Spuren (11', 12') angeordnet sind, und
die Beleuchtungsvorrichtung (38) mehrere Lichtquellen (38.1) umfasst, welche Lichtquellen derart angeordnet sind, dass eine der Spuren (11') mittels einer der jeweiligen Lichtquellen (38.1) und eine andere der Spuren (12') mittels einer anderen der jeweiligen Lichtquellen (38.1) beleuchtet werden kann.

13. Vorrichtung (5) nach einem der Ansprüche 5-12, wobei die Massskala (10) derart ausgebildet ist, dass ein Rand der jeweiligen Markierung (11, 12) an einen Flächenbereich angrenzt, welcher einfallendes Licht (39, B) gerichtet reflektiert und derart angeordnet ist, dass mittels der jeweiligen Lichtquelle (38.1) erzeugtes Licht (39) an dem Flächenbereich derart reflektiert wird, dass das jeweils reflektierte Licht (BR) nicht auf das erste Linsenelement (33) trifft.

14. Vorrichtung (5) nach einem der Ansprüche 5-13, wobei die jeweilige Markierung (11, 12) derart ausgebildet ist, dass an der Markierung (11, 12), falls diese mittels der Beleuchtungsvorrichtung (38) beleuchtet ist, Streulicht (BS) erzeugt wird, welches durch das erste Linsenelement (33) in den Block (31, 31A, 31B) eindringen kann.

15. Vorrichtung (5) nach einem der Ansprüche 5-14, wobei zwischen der jeweiligen Lichtquelle (38,1) und dem Block (31) ein Blendenkörper (50) angeordnet ist, welcher für Licht der jeweiligen Lichtquelle (38.1) nicht transparent ist.

16. Vorrichtung (5) nach Anspruch 15, wobei der Blendenkörper (50) eine erste Kammer (50.1), in welcher der Block (31) platziert ist, und eine zweite Kammer (50.2), in welcher die jeweilige Lichtquelle (38.1) der Beleuchtungsvorrichtung (38) platziert ist, aufweist.

17. Vorrichtung (5) nach Anspruch 16, wobei die zweite Kammer (50.2) auf einer der Massskala (10) zugewandten Seite eine Öffnung (50.4) aufweist, welche derart angeordnet ist, dass der jeweilige Bereich (10.1) der Massskala mittels der Lichtquelle (38.1) der Beleuchtungsvorrichtung (38) durch diese Öffnung (50.4) der zweiten Kammer (50.2) beleuchtbar ist, und
die erste Kammer (50.1) auf einer der Massskala (10) zugewandten Seite eine Öffnung (50.3) aufweist, welche derart angeordnet ist, dass das Bild des jeweiligen Bereichs (10.1) der Massskala (10) mittels des telezentrischen optischen Systems (30) durch diese Öffnung (50.3) der ersten Kammer (50.1) erzeugbar ist.

18. Vorrichtung (5) nach einem der Ansprüche 1-17, wobei der Block (31, 31A, 31B) ein Formteil aus Kunststoff ist.

19. Führungssystem (1),
mit einem ersten Körper (2) und einem relativ zum ersten Körper bewegbaren, an dem ersten Körper geführten zweiten Körper (3) und
einer Vorrichtung (5) zur Bestimmung einer Position nach einem der Ansprüche 1-18,
wobei die Massskala (10) ortsfest bezüglich des ersten Körpers (2) und der Messkopf (21, 21A, 21B) ortsfest bezüglich des zweiten Körpers (3) angeordnet ist.

20. Führungssystem nach Anspruch 19, wobei
die jeweilige Markierung (11, 12) in den ersten Körper (2) integriert ist oder an einer Oberfläche (2.1) des ersten Körpers (2) ausgebildet ist.

21. Führungssystem nach einem der Ansprüche 19 oder 20, wobei der Messkopf (21, 21A, 21B) an dem zweiten Körper (3) befestigt ist.

22. Führungssystem nach einem der Ansprüche 19-21, welches als Linearführung (1) ausgebildet, wobei der erste Körper (2) eine Führungsschiene ist, längs welcher der zweite Körper (3) linear bewegbar ist.
